(19) Europäisches Patentamt / European Patent Office / Office européen des brevets

(11) **EP 4 170 737 B1**

(12) **EUROPEAN PATENT SPECIFICATION**

(45) Date of publication and mention
of the grant of the patent:
**13.05.2026 Bulletin 2026/20**

(21) Application number: **21824862.3**

(22) Date of filing: **14.06.2021**

(51) International Patent Classification (IPC):
**H10N 10/13** *(2023.01)*   **H02N 11/00** *(2006.01)*
**H10N 10/17** *(2023.01)*

(52) Cooperative Patent Classification (CPC):
**H10N 10/13; Y02T 10/12**

(86) International application number:
**PCT/KR2021/007394**

(87) International publication number:
**WO 2021/256802 (23.12.2021 Gazette 2021/51)**

(54) **POWER GENERATION DEVICE**

STROMERZEUGUNGSVORRICHTUNG

DISPOSITIF DE GÉNÉRATION D'ÉNERGIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.06.2020 KR 20200074233**

(43) Date of publication of application:
**26.04.2023 Bulletin 2023/17**

(73) Proprietor: **LG Innotek Co., Ltd.**
**Seoul 07796 (KR)**

(72) Inventors:
• **JEON, Ji Hwan**
**Seoul 07796 (KR)**
• **KIM, Jung Ho**
**Seoul 07796 (KR)**
• **AN, Sang Hun**
**Seoul 07796 (KR)**

(74) Representative: **M. Zardi & Co S.A.**
**Via G. B. Pioda, 6**
**6900 Lugano (CH)**

(56) References cited:
EP-A1- 2 713 412      EP-A1- 3 780 125
EP-A1- 4 092 768      EP-A1- 4 092 770
WO-A1-2019/194595     JP-A- 2014 212 632
KR-A- 20130 073 042   KR-A- 20190 064 373
KR-A- 20190 097 380   KR-B1- 102 083 611
US-A1- 2018 149 061

**Description**

[Technical Field]

The present invention relates to a power generation device, and more specifically, to a power generation device which generates power using a difference in temperature between a lower-temperature part and a high-temperature part of a thermoelectric element.

[Background Art]

A thermoelectric effect is a direct energy conversion phenomenon between heat and electricity that occurs due to the movement of electrons and holes in a material.

A thermoelectric element is generally referred to as an element using a thermoelectric effect and has a structure in which P-type thermoelectric materials and N-type thermoelectric materials are disposed between and bonded to metal electrodes to form PN junction pairs.

Thermoelectric elements may be divided into elements using a change in electrical resistance depending on a change in temperature, elements using the Seebeck effect in which an electromotive force is generated due to a difference in temperature, elements using the Peltier effect in which heat absorption or heating occurs due to a current, and the like.

Thermoelectric elements have been variously applied to home appliances, electronic components, communication components, and the like. As an example, thermoelectric elements may be applied to cooling apparatuses, heating apparatuses, power generation devices, and the like. Therefore, the demand for the thermoelectric performance of the thermoelectric element is gradually increasing.

Recently, there are needs to generate power using waste heat at high temperature generated by engines of vehicles, vessels, and the like and thermoelectric elements. In this case, a duct through which a first fluid flows may be disposed at a side of a lower-temperature part of a thermoelectric element, radiation fins may be disposed at a side of a high-temperature part of the thermoelectric element, and a second fluid having a higher temperature than the first fluid may pass through the radiation fins. Accordingly, electricity can be generated due to a difference in temperature between the lower-temperature part and the high-temperature part of the thermoelectric element, and the power generation performance may be changed according to a structure of a power generation device.

WO 2019194595 A1 discloses a heat converter comprising: a plurality of unit modules respectively arranged in a first direction and a second direction that intersects the first direction; and a frame, which supports the plurality of unit modules, allows cooling water to flow in through one surface arranged in the first direction, and allows the cooling water to be discharged through the other surface arranged in the first direction, wherein each unit module includes: a cooling water passage chamber having first and second surfaces arranged to be spaced in the first direction, third and fourth surfaces arranged to be spaced in a third direction that intersects the first direction and the second direction, a fifth surface arranged to be spaced in the second direction such that cooing water flows therein, and a sixth surface from which cooling water is discharged; a first thermoelectric module arranged on the first surface; and a second thermoelectric module arranged on the second surface, the first thermoelectric module includes a plurality of group thermoelectric elements, each group thermoelectric element includes a plurality of thermoelectric elements, which have the same minimum spacing distance from the fourth surface in the third direction, and the plurality of thermoelectric elements in at least one group thermoelectric element of the plurality of group thermoelectric elements are electrically connected to each other.

[Disclosure]

[Technical Problem]

The present invention is directed to providing a power generation device which generates electricity using a difference in temperature between a lower-temperature part and a high-temperature part of a thermoelectric element.

[Technical Solution]

One aspect of the present invention provides a power generation device including a fluid flow part in which a fluid passes through a flow path pipe formed in the fluid flow part and which includes a first surface, a second surface opposite to the first surface, a third surface between the first surface and the second surface, a fourth surface opposite to the third surface, a fifth surface between the first surface, the second surface, the third surface, and the fourth surface, and a sixth surface opposite to the fifth surface and a first thermoelectric module disposed on the first surface, wherein a fluid inlet and a fluid outlet are disposed in the third surface, the flow path pipe is formed to connect from the fluid inlet to the fluid outlet, the flow path pipe includes a plurality of first flow path parts disposed in a first direction, a plurality of second flow path parts disposed in a second direction perpendicular to the first direction, and a plurality of bent parts disposed between and connected to the plurality of first flow path parts and the plurality of second flow path parts, a first section, a second section, and a third section of the fluid flow part are sequentially disposed from the third surface to the fourth surfacea plurality of through-holes passing through the first surface are formed in the fluid flow part, wherein the plurality of first flow path parts disposed in the second section and the bent parts connecting the plurality of first flow path parts disposed in the second section are disposed in a region defined by a virtual line connecting the plurality of through-holes, the fluid inlet and the fluid outlet are disposed spaced apart from each other in the first direction, and a distance between the fluid inlet and the fluid outlet is greater than or equal to a distance between the second flow path part closest to the fifth surface among the plurality of second flow path parts and the second flow path part closest to the sixth surface among the plurality of second flow path parts.

[Advantageous Effects]

According to embodiments of the present invention, a power generation device with a superior power generation performance can be obtained. In addition, according to embodiments of the present invention, the power generation device with an improved heat transfer efficiency to a thermoelectric element can be obtained.

In addition, according to embodiments of the present invention, a high cooling efficiency per an area can be obtained by improving a flow path passing through a cooling part of a power generation device.

[Description of Drawings]

FIG. 1 is a perspective view illustrating a power generation system according to one embodiment of the present invention.

FIG. 2 is an exploded perspective view illustrating the power generation system according to one embodiment of the present invention.

FIG. 3 is a perspective view illustrating a power generation device included in the power generation system according to one embodiment of the present invention.

FIG. 4 is an exploded view illustrating the power generation device according to one embodiment of the present invention.

FIG. 5 is a perspective view illustrating a power generation module included in the power generation device according to one embodiment of the present invention.

FIG. 6 is an exploded perspective view illustrating the power generation module according to one embodiment of the present invention.

FIG. 7 is a set of partially enlarged views illustrating the power generation module according to one embodiment of the present invention.

FIGS. 8 and 9 are a cross-sectional view and a perspective view illustrating a thermoelectric element included in the power generation module according to one embodiment of the present invention.

FIG. 10 is a top view illustrating the power generation module according to one embodiment of the present invention.

FIG. 11 is a cross-sectional view illustrating a fluid flow part according to one embodiment of the present invention.

FIG. 12 is a cross-sectional view illustrating a fluid flow part according to another embodiment of the present invention.

FIG. 13 is a cross-sectional view illustrating a fluid flow part according to still another embodiment of the present invention.

FIG. 14 is a view illustrating a fluid moving path of the fluid flow part of FIG. 13.

FIG. 15A is a view showing a simulation result of a heat distribution in a flow path shape of FIG. 11, FIG. 15B is a view showing a simulation result of a heat distribution in a flow path shape of FIG. 12, and FIG. 15C is a view showing a simulation result of a heat distribution in a flow path shape of FIG. 13.

FIG. 16 is a view illustrating a power generation system according to another embodiment of the present invention.

FIG. 17 is a view illustrating a power generation system according to still another embodiment of the present invention.

[Modes of the Invention]

Hereinafter, exemplary embodiments of the present invention will be described in detail with reference to the accompanying drawings.

In addition, unless clearly and specifically defined otherwise by context, all terms (including technical and scientific terms) used herein can be interpreted as having meanings customarily understood by those skilled in the art, and meanings of generally used terms, such as those defined in commonly used dictionaries, will be interpreted by considering contextual meanings of the related technology.

In addition, the terms used in the embodiments of the present invention are considered in a descriptive sense and not for limiting the present invention.

In the present specification, unless specifically indicated otherwise by the context, singular forms may include the plural forms thereof, and in a case in which "at least one (or one or more) among A, B, and C" is described, this may include at least one combination among all possible combinations of A, B, and C.

In addition, in descriptions of components of the present invention, terms such as "first," "second," "A," "B," "(a)," and "(b)" can be used.

The terms are only to distinguish one element from another element, and an essence, order, and the like of the element are not limited by the terms.

In addition, when an element is referred to as being "connected" or "coupled" to another element, such a description may include not only a case in which the element is directly connected or coupled to another element but also a case in which the element is connected or coupled to another element with still another element disposed therebetween.

In addition, in a case in which any one element is described as being formed or disposed "on" or "under" another element, such a description includes not only a case in which the two elements are formed or disposed in direct contact with each other but also a case in which one or more other elements are formed or disposed between the two elements. In addition, when one element is described as being disposed "on or under" another element, such a description may include a case in which the one element is disposed at an upper side or lower side with respect to another element.

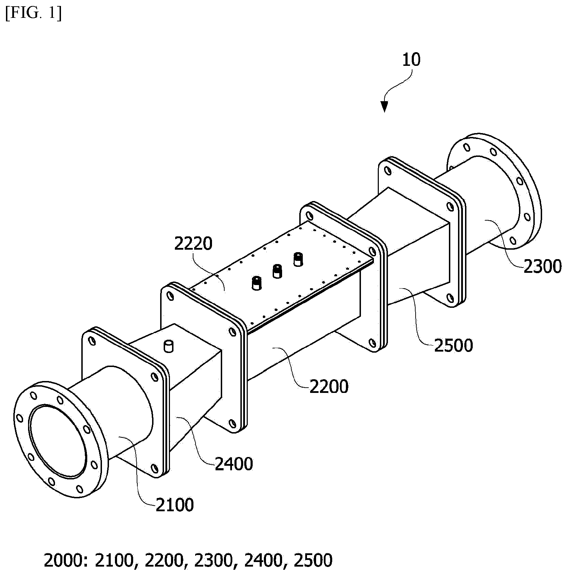

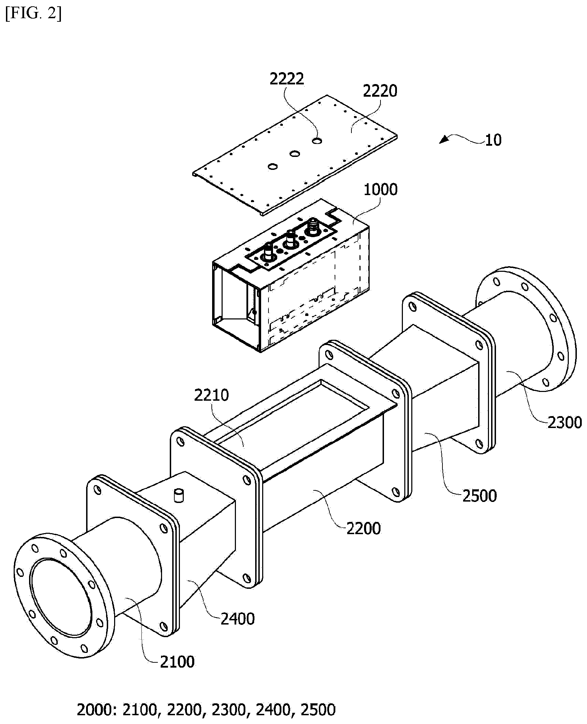

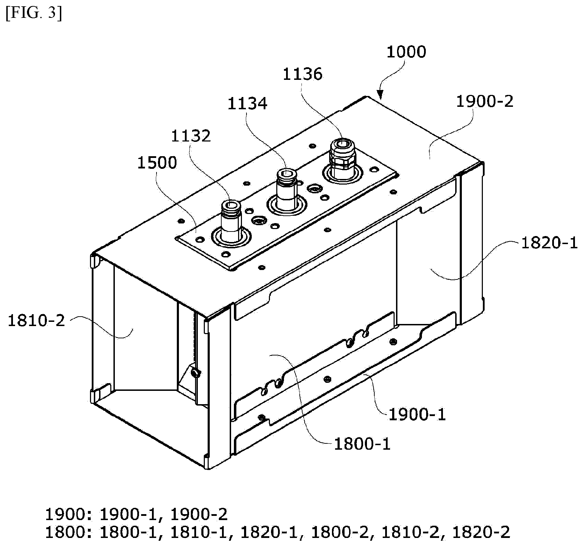

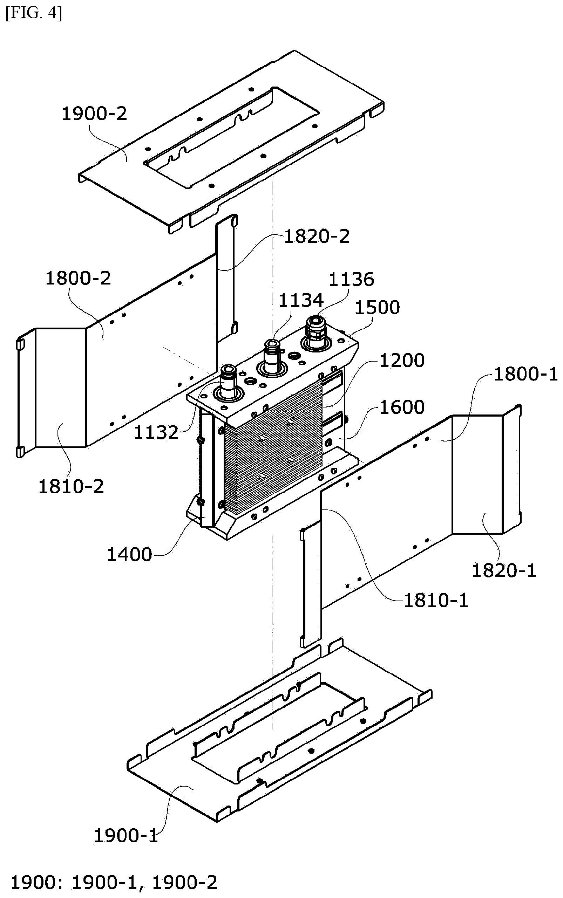

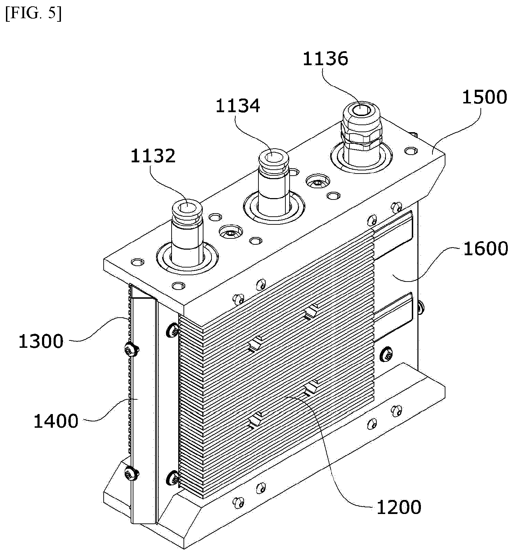

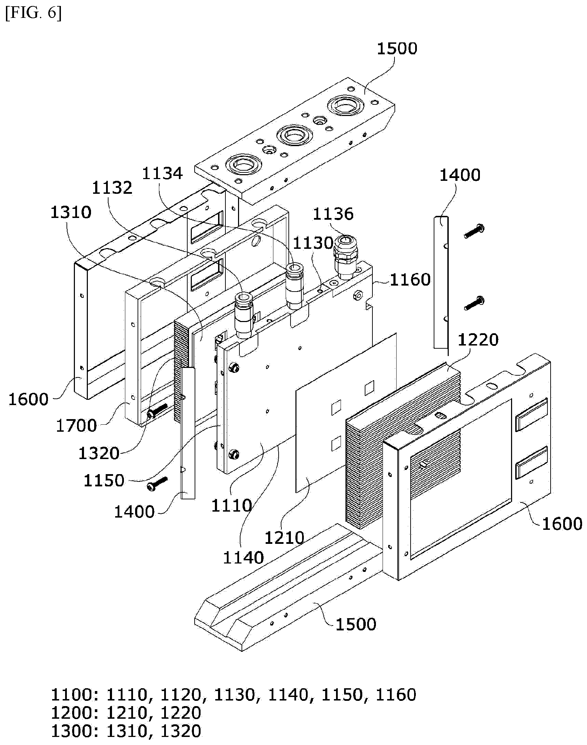

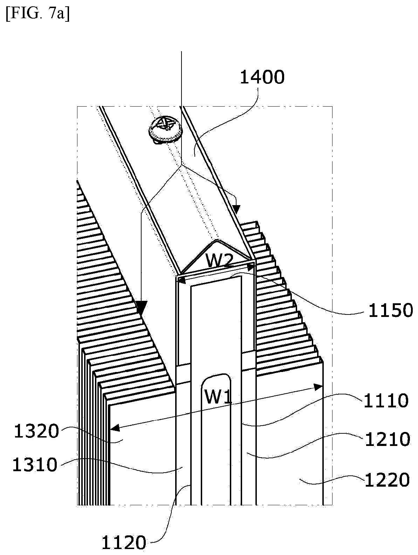

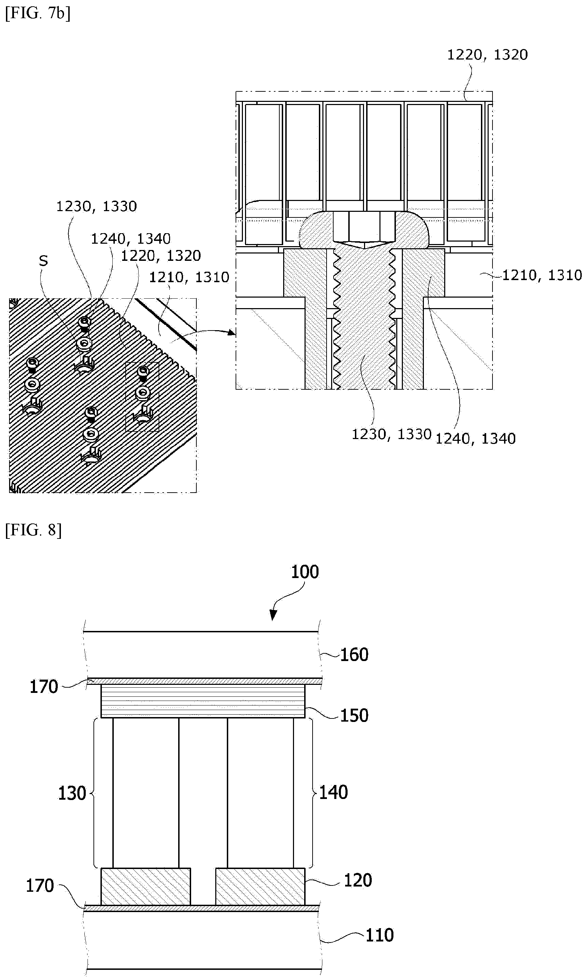

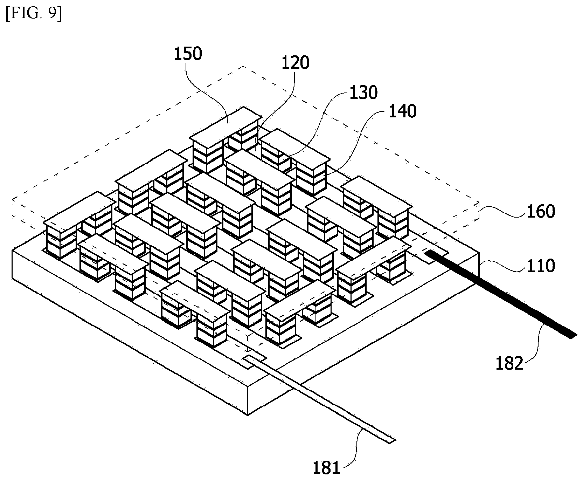

FIG. 1 is a perspective view illustrating a power generation system according to one embodiment of the present invention, and FIG. 2 is an exploded perspective view illustrating the power generation system according to one embodiment of the present invention. FIG. 3 is a perspective view illustrating a power generation device included in the power generation system according to one embodiment of the present invention, and FIG. 4 is an exploded view illustrating the power generation device according to one embodiment of the present invention. FIG. 5 is a perspective view illustrating a power generation module included in the power generation device according to one embodiment of the present invention, and FIG. 6 is an exploded perspective view illustrating the power generation module according to one embodiment of the present invention. FIG. 7 is a set of partially enlarged views illustrating the power generation module according to one embodiment of the present invention, and FIGS. 8 and 9 are a cross-sectional view and a perspective view illustrating a thermoelectric element included in the power generation module according to one embodiment of the present invention.

Referring to FIGS. 1 and 2, a power generation system 10 includes a power generation device 1000 and a fluid pipe 2000.

A fluid introduced into the fluid pipe 2000 may be a heat source generated by an engine of a vehicle, a vessel, or the like, a power plant, a steel mill, or the like but is not limited thereto. A temperature of the fluid discharged from the fluid pipe 2000 is lower than a temperature of the fluid introduced into the fluid pipe 2000. For example, the temperature of the fluid introduced into the fluid pipe 2000 may be 100 °C or higher, preferably 200 °C or higher, and more preferably 220 °C to 250 °C but is not limited thereto and may be variously changed according to a difference in temperature between a lower-temperature part and a high-temperature part of the thermoelectric element.

The fluid pipe 2000 includes a fluid inlet part 2100, a fluid passing part 2200, and a fluid outlet part 2300. The fluid introduced through the fluid inlet part 2100 passes through the fluid passing part 2200 and is discharged through the fluid outlet part 2300. In this case, the power generation device 1000 according to the embodiment of the present invention is disposed in the fluid passing part 2200, the power generation device 1000 generates electricity using a difference in temperature between a first fluid passing through the power generation device 1000 and a second fluid passing through the fluid passing part 2200. In this case, the first fluid may be a cooling fluid, and a second fluid may be a high temperature fluid of which a temperature is higher than a temperature of the first fluid. The power generation device 1000 according to the embodiment of the present invention may generate electricity using a difference in temperature between the first fluid flowing on one surface of the thermoelectric element and the second fluid flowing on the other surface of the thermoelectric element.

When a cross-sectional shape of each of the fluid inlet part 2100 and the fluid outlet part 2300 is different from a cross-sectional shape of the fluid passing part 2200, the fluid pipe 2000 may further include a first connecting part 2400 connecting the fluid inlet part 2100 and the fluid passing part 2200 and a second connecting part 2500 connecting the fluid passing part 2200 and the fluid outlet part 2300. For example, each of the fluid inlet part 2100 and the fluid outlet part 2300 may have a cylindrical shape. However, the fluid passing part 2200 in which the power generation device 1000 is disposed may have a quadrangular container shape or polygonal container shape. Accordingly, one end of the fluid inlet part 2100 and one end of the fluid passing part 2200, and the other end of the fluid outlet part 2300 and the other end of the fluid passing part 2200 may be respectively connected through the first connecting part 2400 and the second connecting part 2500 of which one ends have the cylindrical shapes and the other ends have the quadrangular container shapes.

In this case, the fluid inlet part 2100 and the first connecting part 2400, the first connecting part 2400 and the fluid passing part 2200, the fluid passing part 2200 and the second connecting part 2500, the second connecting part 2500 and the fluid outlet part 2300, and the like may be connected to each other by fastening members.

As described above, the power generation device 1000 according to one embodiment of the present invention may be disposed in the fluid passing part 2200. In order to easily assemble the power generation system 10, one surface of the fluid passing part 2200 may be designed as a structure to be opened and closed. After the one surface 2210 of the fluid passing part 2200 is opened, the power generation device 1000 may be accommodated in the fluid passing part 2200, and the opened one surface 2210 of the fluid passing part 2200 may be covered by a cover 2220. In this case, the cover 2220 may be fastened to the opened one surface 2210 of the fluid passing part 2200 by a plurality of fastening members.

When the first fluid is supplied to the power generation device 1000 from the outside and then discharged to the outside, and a wire connected to the power generation device 1000 is withdrawn to the outside, a plurality of holes 2222 may also be formed in the cover 2220 in order to receive and discharge the first fluid and withdraw the wire.

Referring to FIGS. 3 to 7, the power generation device 1000 according to the embodiment of the present invention includes a fluid flow part 1100, a first thermoelectric module 1200, a second thermoelectric module 1300, a branching part 1400, a separation member 1500, shield members 1600, and an insulation member 1700. In addition, the power generation device 1000 according to the embodiment of the present invention further includes guide plates 1800 and support frames 1900.

As illustrated in FIG. 5, the fluid flow part 1100, the first thermoelectric module 1200, the second thermoelectric module 1300, the branching part 1400, the separation member 1500, the shield members 1600, and the insulation member 1700 may be assembled as one module.

The power generation device 1000 according to the embodiment of the present invention may generate power using a difference in temperature between the first fluid flowing through an inner portion of the fluid flow part 1100 and the second fluid passing heatsinks 1220 and 1320 of the first thermoelectric module 1200 and the second thermoelectric module 1300 which are disposed outside the fluid flow part 1100.

In the present specification, a temperature of the first fluid flowing through the inner portion of the fluid flow part 1100 may be less than a temperature of the second fluid passing the heatsinks 1220 and 1320 of the thermoelectric modules 1200 and 1300 disposed outside the fluid flow part 1100. In the present specification, the first fluid may be a fluid for cooling. To this end, the first thermoelectric module 1200 may be disposed on one surface of the fluid flow part 1100, and the second thermoelectric module 1300 may be disposed on the other surface of the fluid flow part 1100. In this case, among two surfaces of each of the first thermoelectric module 1200 and the second thermoelectric module 1300, a surface disposed to face the fluid flow part 1100 becomes the lower-temperature part, and power may be generated using a difference in temperature between the lower-temperature part and the high-temperature part. Accordingly, in the present specification, the fluid flow part 1100 may be referred to as a cooling part or duct.

The first fluid introduced into the fluid flow part 1100 may be a water but is not limited thereto and may be any type fluid having a cooling function. The temperature of the first fluid introduced into the fluid flow part 1100 may be less than 100 °C, preferably less than 50 °C, and more preferably less than 40 °C but is not limited thereto. The temperature of the first fluid which passes through the fluid flow part 1100 and is discharged may be greater than the temperature of the first fluid introduced into the fluid flow part 1100. The fluid flow part 1100 includes a first surface 1110, a second surface 1120 disposed opposite to the first surface 1110 and parallel to the first surface 1110, a third surface 1130 disposed between the first surface 1110 and the second surface 1120, a fourth surface 1140 disposed between the first surface 1110 and the second surface 1120 to be opposite to the third surface 1130, a fifth surface 1150 disposed between the first surface 1110, the second surface 1120, the third surface 1130, and the third surface 1140, and a sixth surface 1160 disposed opposite to the fifth surface 1150, and the first fluid passes through the inner portion of the fluid flow part 1100. When the first thermoelectric module 1200 and the second thermoelectric module 1300 are respectively disposed on the first surface 1110 and the second surface 1120 of the fluid flow part 1100, the third surface 1130 may be a surface disposed in a direction in which the first fluid is introduced and discharged, and the fifth surface 1150 may be a surface disposed in a direction in which the second fluid is introduced. To this end, a first fluid inlet 1132 and a first fluid outlet 1134 may be formed in the third surface 1130 of the fluid flow part 1100. The first fluid inlet 1132 and the first fluid outlet 1134 may be connected to a flow path pipe in the fluid flow part 1100. Accordingly, the first fluid introduced from the first fluid inlet 1132 may pass through the flow path pipe and may be discharged from the first fluid outlet 1134.

Although not illustrated in the drawings, radiation fins may also be disposed on an inner wall of the fluid flow part 1100. A shape, the number of the radiation fins, an area of the fluid flow part 1100 occupied by the radiation fins, and the like may be variously changed according to a temperature of the first fluid, a temperature of waste heat, a desired power generation capacity, and the like. An area of the inner wall of the fluid flow part 1100 occupied by the radiation fins may be less than, for example, 1 to 40% of a cross-sectional area of the fluid flow part 1100. Accordingly, a high thermoelectric conversion efficiency can be obtained without hindering movement of the first fluid. In this case, the radiation fins may have a shape which does not hinder the movement of the first fluid. For example, the radiation fins may be formed in a direction in which the first fluid flows. That is, the radiation fins may have a plate shape extending in a direction from the first fluid inlet toward the first fluid outlet, and a plurality of radiation fins may be disposed to be spaced a predetermined distance from each other. The radiation fins may also be integrally formed with the inner wall of the fluid flow part 1100.

According to the embodiment of the present invention, a direction of the second fluid flowing through the fluid passing part 2200 and the receiving/discharging direction of the first fluid flowing through the fluid flow part 1100 may be different. For example, the receiving/discharging direction of the first fluid and the passing direction of the second fluid may be different by about 90°. Accordingly, the uniform thermal conversion performance can be obtained in an entire region.

Meanwhile, the first thermoelectric module 1200 may be disposed on the first surface 1110 of the fluid flow part 1100, and the second thermoelectric module 1300 may be disposed to be symmetrical to the first thermoelectric module 1200 on the second surface 1120 of the fluid flow part 1100.

The first thermoelectric module 1200 and the second thermoelectric module 1300 may be fastened to the fluid flow part 1100 using screws or coil springs. Accordingly, the first thermoelectric module 1200 and the second thermoelectric module 1300 may be stably coupled to the surfaces of the fluid flow part 1100. Alternatively, at least one of the first thermoelectric module 1200 and the second thermoelectric module 1300 may also be bonded to the surface of the fluid flow part 1100 using a thermal interface material (TIM). Uniformity of heat applied to the first thermoelectric module 1200 and the second thermoelectric module 1300 may be uniformly controlled even at high temperatures using the coil springs, the TIM, and/or the screws.

Meanwhile, as illustrated in FIG. 7A, the first thermoelectric module 1200 and the second thermoelectric module 1300 respectively include thermoelectric elements 1210 and 1310 disposed on the first surface 1110 and the second surface 1120 and the heatsinks 1220 and 1320 disposed on the thermoelectric elements 1210 and 1310. As described above, among the two surfaces of each of the thermoelectric elements 1210 and 1310, when the fluid flow part 1100 through which the first fluid flows is disposed on one surface, the heatsinks 1220 and 1320 are disposed on the other surface, and the second fluid passes the heatsinks 1220 and 1320, a difference in temperature between heat absorption surfaces and heat radiation surfaces of the thermoelectric elements 1210 and 1310 may be increased, and thus, a thermoelectric conversion efficiency can be improved. In this case, when a direction from the first surface 1110 toward the thermoelectric element 1210 and the heatsink 1220 is defined as a first direction, a length of the heatsink 1220 in the first direction may be greater than a length of the thermoelectric element 1210 in the first direction. Accordingly, since a contact area between the second fluid and the heatsink 1220 increases, a temperature of the heat absorption surface of the thermoelectric element 1210 may increase.

In this case, referring to FIG. 7B, the heatsinks 1220 and 1320 and the thermoelectric elements 1210 and 1310 may be fastened by a plurality of fastening members 1230 and 1330. In this case, the fastening members 1230 and 1330 may be coil springs, screws, or the like. To this end, through-holes S through which the fastening members 1230 and 1330 pass may be formed in at least parts of the radiation fins 1220 and 1320 and the thermoelectric elements 1210 and 1310. In this case, separate insulation insertion members 1240 and 1340 may be further disposed between the through-holes S and the fastening members 1230 and 1330. The separate insulation insertion members 1240 and 1340 may be insulation insertion members surrounding outer circumferential surfaces of the fastening members 1230 and 1330 or insulation insertion members surrounding wall surfaces of the through-holes S. For example, each of the insulation insertion members 1240 and 1340 may have a ring shape. Inner circumferential surfaces of the insulation insertion members 1240 and 1340 having the ring shape may be disposed on the outer circumferential surface of the fastening members 1230 and 1330, and outer circumferential surfaces of the insulation insertion members 1240 and 1340 may be disposed on inner circumferential surfaces of the through-hole S. Accordingly, the fastening members 1230 and 1330, the heatsinks 1220 and 1320, and the thermoelectric elements 1210 and 1310 may be insulated from each other.

Meanwhile, each of the insulation insertion members 1240 and 1340 may have the shape illustrated in FIG. 7B. For example, as illustrated in FIG. 7B, the insulation insertion members 1240 and 1340 may form steps in regions of the through-holes S formed in substrates of the thermoelectric elements 1210 and 1310 and may be disposed to surround parts of the wall surfaces of the through-holes S. Alternatively, the insulation insertion members 1240 and 1340 may form steps in regions of the through-holes S formed in the substrates of the thermoelectric elements 1210 and 1310 and may also be disposed to extend to surfaces on which electrodes (not shown) of the thermoelectric elements 1210 and 1310 are disposed along the wall surfaces of the through-holes S.

In this case, each of the thermoelectric elements 1210 and 1310 may have a structure of a thermoelectric element 100 illustrated in FIGS. 8 and 9. Referring to FIGS. 8 and 9, the thermoelectric element 100 includes a lower substrate 110, lower electrodes 120, P-type thermoelectric legs 130, N-type thermoelectric legs 140, upper electrodes 150, and an upper substrate 160.

The lower electrodes 120 are disposed between the lower substrate 110 and the P-type thermoelectric legs 130 and the N-type thermoelectric legs 140, and the upper electrodes 150 are disposed between the upper substrate 160 and the P-type thermoelectric legs 130 and the N-type thermoelectric legs 140. Accordingly, a plurality of P-type thermoelectric legs 130 and a plurality of N-type thermoelectric legs 140 are electrically connected by the lower electrodes 120 and the upper electrodes 150. A pair of P-type thermoelectric leg 130 and N-type thermoelectric leg 140 which are disposed between and electrically connected to the lower electrodes 120 and the upper electrode 150 may form a unit cell.

For example, when a voltage is applied to the lower electrodes 120 and the upper electrodes 150 through lead wires 181 and 182, due to the Peltier effect, the substrate through which a current flows from the P-type thermoelectric legs 130 to the N-type thermoelectric legs 140 may absorb heat to serve as a cooling part, and the substrate through which the current flows from the N-type thermoelectric legs 140 to the P-type thermoelectric legs 130 may be heated to serve as a heating part. Alternatively, when different temperatures are applied to the lower electrodes 120 and the upper electrodes 150, due to the Seebeck, electric charges may move through the P-type thermoelectric legs 130 and the N-type thermoelectric legs 140, and thus electricity can be generated.

In this case, each of the P-type thermoelectric leg 130 and the N-type thermoelectric leg 140 may be a bismuth-telluride (Bi-Te)-based thermoelectric leg mainly including Bi and Te. The P-type thermoelectric leg 130 may be a Bi-Te-based thermoelectric leg including at least one among antimony (Sb), nickel (Ni), aluminum (Al), copper (Cu), silver (Ag), lead (Pb), boron (B), gallium (Ga), Te, Bi, and indium (In). As an example, the P-type thermoelectric leg 130 may include Bi-Sb-Te at 99 to 99.999 wt% as a main material and at least one material among Ni, Al, Cu, Ag, Pb, B, Ga, and In at 0.001 to 1 wt% based on a total weight of 100 wt%. The N-type thermoelectric leg 140 may be a Bi-Te-based thermoelectric leg including at least one among Se, Ni, Al, Cu, Ag, Pb, B, Ga, Te, Bi, and In. As an example, the N-type thermoelectric leg 140 may include Bi-Se-Te at 99 to 99.999 wt% as a main material and at least one material among Ni, Al, Cu, Ag, Pb, B, Ga, and In at 0.001 to 1 wt% based on a total weight of 100 wt%.

Each of the P-type thermoelectric leg 130 and the N-type thermoelectric leg 140 may be formed in a bulk type or stack type. Generally, the bulk type P-type thermoelectric leg 130 or the bulk type N-type thermoelectric leg 140 may be formed through a process in which a thermoelectric material is thermally processed to manufacture an ingot, the ingot is ground and strained to obtain a powder for a thermoelectric leg, the powder is sintered, and the sintered powder is cut. In this case, each of the P-type thermoelectric leg 130 and the N-type thermoelectric leg 140 may be a polycrystalline thermoelectric leg. As described above, when each of the P-type thermoelectric leg 130 and the N-type thermoelectric leg 140 is the polycrystalline thermoelectric leg, the strength of each of the P-type thermoelectric leg 130 and the N-type thermoelectric leg 140 may increase. The stacked P-type thermoelectric leg 130 or the stacked N-type thermoelectric leg 140 may be formed in a process in which a paste containing a thermoelectric material is applied on base members each having a sheet shape to form unit members, and the unit members are stacked and cut.

In this case, the P-type thermoelectric leg 130 and the N-type thermoelectric leg 140 provided in the pair may have the same shape and volume or may have different shapes and volumes. For example, since electrical conduction characteristics of the P-type thermoelectric leg 130 and the N-type thermoelectric leg 140 are different, a height or cross-sectional area of the N-type thermoelectric leg 140 may also be different from that of the P-type thermoelectric leg 130.

In this case, the P-type thermoelectric leg 130 or the N-type thermoelectric leg 140 may have a cylindrical shape, a polygonal column shape, an elliptical column shape, or the like.

The performance of a thermoelectric element according to one embodiment of the present invention may be expressed as a thermoelectric performance figure of merit (ZT). The thermoelectric performance figure of merit (ZT) may be expressed by Equation 1.

[Equation 1]

$$ZT = \alpha^2 \cdot \sigma \cdot T/k$$

Here, $\alpha$ denotes the Seebeck coefficient [V/K], $\sigma$ denotes electrical conductivity [S/m], and $\alpha^2 \cdot \sigma$ denotes a power factor [W/mK$^2$]. In addition, T denotes temperature, and k denotes thermal conductivity [W/mK]. k may be expressed as a·cp·p, wherein a denotes thermal diffusivity [cm$^2$/S], cp denotes specific heat [J/gK], and $\rho$ denotes density [g/cm$^3$].

In order to obtain the thermoelectric performance figure of merit (ZT) of a thermoelectric element, a Z value (V/K) is measured using a Z meter, and the thermoelectric performance figure of merit (ZT) may be calculated using the measured Z value.

In this case, each of the lower electrodes 120 disposed between the lower substrate 110 and the P-type thermoelectric legs 130 and the N-type thermoelectric legs 140 and the upper electrodes 150 disposed between the upper substrate 160 and the P-type thermoelectric legs 130 and the N-type thermoelectric legs 140 may include at least one among Cu, Ag, Al, and Ni and may have a thickness of 0.01 mm to 0.3 mm. When the thickness of the lower electrode 120 or the upper electrode 150 is less than 0.01 mm, an electrode function is degraded, and thus the electrical conductivity performance may be degraded, and when the thickness is greater than 0.3 mm, a resistance increases, and thus a conduction efficiency can be lowered.

In addition, each of the lower substrate 110 and the upper substrate 160, which are opposite to each other, may be a metal substrate, and a thickness of the lower substrate 110 and the upper substrate 160 may be in the range of 0.1 mm to 1.5 mm. When the thickness of the metal substrate is less than 0.1 mm or greater than 1.5 mm, since a heat radiation characteristic or thermal conductivity may become excessively high, the reliability of the thermoelectric element may be degraded. In addition, when each of the lower substrate 110 and the upper substrate 160 is the metal substrates, insulation layers 170 may be further formed between the lower substrate 110 and the lower electrodes 120 and between the upper substrate 160 and the upper electrodes 150. Each of the insulation layers 170 may include a material having a thermal conductivity of 1 to 20 W/mK. In this case, the insulation layer 170 may be a resin composition including at least one of epoxy resin and silicon resin and an inorganic material, a layer formed of a silicon composite including silicon and an inorganic material, or an aluminum oxide layer. In this case, the inorganic material may be at least one among an oxide, a carbide, and a nitride combined with aluminum, boron, silicon, or the like.

In this case, sizes of the lower substrate 110 and the upper substrate 160 may also be different. That is, a volume, a thickness, or an area of one of the lower substrate 110 and the upper substrate 160 may be greater than a volume, a thickness, or an area of the other. In this case, the thickness may be a thickness in a direction from lower substrate 110 toward the upper substrate 160, and the area may be an area in a direction perpendicular to the direction from the lower substrate 110 toward the upper substrate 160. Accordingly, the heat absorption or radiation performance of the thermoelectric element can be improved. Preferably, at least one of the volume, the thickness, and the area of the lower substrate 110 may be formed greater than that of the upper substrate 160. In this case, when the lower substrate 110 is disposed in a high-temperature region for the Seebeck effect or applied as a heating region for the Peltier effect, or a sealing member for protecting the thermoelectric element, which will be described below, from an external environment is disposed on the lower substrate 110, at least one of the volume, the thickness, and the area of the lower substrate 110 may be formed greater than that of the upper substrate 160. In this case, the area of the lower substrate 110 may be formed in the range of 1.2 to 5 times the area of the upper substrate 160. When the area of the lower substrate 110 is smaller than 1.2 times the area of the upper substrate 160, an effect of an increase in heat transfer efficiency may not be large, and when the area of the lower substrate 110 is greater than 5 times the area of the upper substrate 160, a heat transfer efficiency may rather be remarkably reduced, and it can be difficult to maintain a basic shape of the thermoelectric module.

In addition, a heat radiation pattern, for example, an uneven pattern, may be formed on a surface of at least one of the lower substrate 110 and the upper substrate 160. Accordingly, the heat radiation performance of the thermoelectric element can be improved. When the uneven pattern is formed on the surface in contact with the P-type thermoelectric legs 130 or the N-type thermoelectric legs 140, a bonding characteristic between the thermoelectric legs and the substrate can also be improved. The thermoelectric element 100 includes the lower substrate 110, the lower electrodes 120, the P-type thermoelectric legs 130, the N-type thermoelectric legs 140, the upper electrodes 150, and the upper substrate 160.

Although not illustrated in the drawings, the sealing member may be further disposed between the lower substrate 110 and the upper substrate 160. The sealing member may be disposed on side surfaces of the lower electrodes 120, the P-type thermoelectric legs 130, the N-type thermoelectric legs 140, and the upper electrodes 150 between the lower substrate 110 and the upper substrate 160. Accordingly, the lower electrodes 120, the P-type thermoelectric legs 130, the N-type thermoelectric legs 140, and the upper electrodes 150 can be sealed from external moisture, heat, contamination, or the like.

In this case, the lower substrate 110 disposed on the fluid flow part 1100 may be an aluminum substrate, and the aluminum substrate may be bonded to the first surface 1110 and the second surface 1120 by a TIM. Since the aluminum substrate has superior heat transfer performance, heat transfer is easy between one surface of two surfaces of each of the thermoelectric elements 1210 and 1310 and the fluid flow part 1100 through which the first fluid flows. In addition, when the aluminum substrate and the fluid flow part 1100 through which the first fluid flows are bonded by the TIM, heat transfer between the aluminum substrate and the fluid flow part 1100 through which the first fluid flows may not be hindered. In this case, the TIM is a material having heat transfer performance and bonding performance and, for example, may be a resin composition including at least one of epoxy resin and silicon resin and an inorganic material. In this case, the inorganic material may be an oxide, a carbide, and a nitride combined with aluminum, boron, silicon, or the like.

Referring to FIGS. 3 to 7 again, in order to improve sealing and insulation effects between the first thermoelectric module 1200, the fluid flow part 1100, and the second thermoelectric module 1300, the power generation module according to the embodiment of the present invention may further include the shield members 1600 and the insulation member 1700. For example, on the surface of the fluid flow part 1100, the insulation member 1700 may be disposed on the surface excluding a region in which the first thermoelectric module 1200 and the second thermoelectric module 1300 are disposed. Accordingly, heat loss of the first fluid and the second fluid can be prevented, and a difference in temperature between the lower-temperature part and the high-temperature part on each of the first thermoelectric module 1200 and the second thermoelectric module 1300 can increase to improve power generation performance. In addition, on the surfaces of the fluid flow part 1100, the shield members 1600 may be disposed on the surfaces excluding regions in which the first thermoelectric module 1200 and the second thermoelectric module 1300 are disposed. Wires and connectors connected to the first thermoelectric module 1200 and the second thermoelectric module 1300 can be protected from external moisture or contamination.

Meanwhile, the guide plates 1800 are plates which guide a flow of the second fluid in the fluid passing part 2200, and the second fluid introduced into the fluid passing part 2200 may flow along the guide plates 1800 and may be discharged.

A first guide plate 1800-1 may be disposed to face the first thermoelectric module 1200, a second guide plate 1800-2 may be disposed to face the second thermoelectric module 1300, and the second fluid may pass between the first thermoelectric module 1200 and the first guide plate 1800-1 and between the second thermoelectric module 1300 and the second guide plate 1800-2.

In this case, two sides of each of the guide plates 1800-1 and 1800-2 may extend to a fluid collection plate 1810-1 or 1810-2 and a fluid diffusion plate 1820-1 or 1820-2. The fluid collection plates 1810-1 and 1810-2 may be an entrance of the fluid passing part 2200, that is, plates extending toward the first connecting part 2400, and the fluid diffusion plates 1820-1 and 1820-2 may be an exit of the fluid passing part 2200, that is, plates extending toward the second connecting part 2500. In this case, the fluid collection plates 1810-1 and 1810-2, the guide plates 1800-1 and 1800-2, and the fluid diffusion plates 1820-1 and 1820-2 may be integrally connected plates, respectively. The first guide plate 1800-1 disposed to face the first thermoelectric module 1200 and the second guide plate 1800-2 disposed to face the second thermoelectric module 1300 may be symmetrically disposed to maintain a predetermined distance. In this case, the distance between the first guide plate 1800-1 and the second guide plate 1800-2 may be a distance in a horizontal direction from the first guide plate 1800-1 toward the second guide plate 1800-2. Accordingly, since the second fluid may pass between the first thermoelectric module 1200 and the first guide plate 1800-1 and between the second thermoelectric module 1300 and the second guide plate 1800-2 at a constant speed, uniform thermoelectric performance may be obtained. However, the first fluid collection plate 1810-1 extending from the first guide plate 1800-1 and the second fluid collection plate 1810-2 extending from the second guide plate 1800-2 may be symmetrically disposed so that a distance therebetween increases toward the entrance of the fluid passing part 2200. In this case, the distance between the first fluid collection plate 1810-1 and the second fluid collection plate 1810-2 may be a distance in a horizontal direction from the first fluid collection plate 1810-1 toward the second fluid collection plate 1810-2. Similarly, the first fluid diffusion plate 1820-1 extending from the first guide plate 1800-1 and the second fluid diffusion plate 1820-2 extending from the second guide plate 1800-2 may be symmetrically disposed so that a distance therebetween increases toward the exit of the fluid passing part 2200. Accordingly, the second fluid introduced through the entrance of the fluid passing part 2200 may be collected by the fluid collection plates 1810-1 and 1810-2, pass between the thermoelectric modules 1200 and 1300 and the guide plates 1800, may be diffused by the fluid diffusion plates 1820-1 and 1820-2, and discharged through the exit of the fluid passing part 2200. Accordingly, since a difference in pressure of the second fluid before and after passing between the thermoelectric modules 1200 and 1300 and the guide plates 1800 can be minimized, a problem that the second fluid flows backward in a direction toward the entrance of the fluid passing part 2200 can be prevented.

In this case, the support frames 1900 supports the first to second guide plates 1800-1 and 1800-2, the first to second fluid collection plates 1810-1 and 1810-2, and the first to second fluid diffusion plates 1820-1 and 1820-2. That is, the support frames 1900 may include a first support frame 1900-1 and a second support frame 1900-2, and the first to second guide plates 1800-1 and 1800-2, the first to second fluid collection plates 1810-1 and 1810-2, and the first to second fluid diffusion plates 1820-1 and 1820-2 may be fixed between the first support frame 1900-1 and the second support frame 1900-2.

Meanwhile, according to the embodiment of the present invention, the branching part 1400 may branch the second fluid introduced into the fluid passing part 2200. The second fluid branched off by the branching part 1400 may pass between the first thermoelectric module 1200 and the first guide plate 1800-1 and between the second thermoelectric module 1300 and the second guide plate 1800-2.

The branching part 1400 may be disposed between the first surface 1110 and the second surface 1120 of the fluid flow part 1100. For example, when the fifth surface 1150 of the fluid flow part 1100 is disposed in the direction in which the second fluid is introduced, the branching part 1400 may be disposed at a side of the fifth surface 1150 of the fluid flow part 1100. Alternatively, the branching part 1400 may also be disposed at a side of the sixth surface 1160 facing the fifth surface 1150 of the fluid flow part 1100 according to an aerodynamic principle.

The branching part 1400 may have a shape in which a distance from the fifth surface 1150 increases toward a center between two ends of the fifth surface 1150 of the fluid flow part 1100 from the two ends of the fifth surface 1150 on the fifth surface 1150. That is, the fifth surface 1150 in which the branching part 1400 is disposed may be substantially perpendicular to the first surface 1110 and the second surface 1120, and the branching part 1400 may be obliquely disposed with respect to the first surface 1110 and the second surface 1120 of the fluid flow part 1100. For example, the branching part 1400 may have an umbrella shape or roof shape. Accordingly, the second fluid, for example, waste heat, may be branched off by the branching part 1400 and guided to come into contact with the first thermoelectric module 1200 and the second thermoelectric module 1300 disposed on two surfaces of the power generation device. That is, the second fluid may be branched off by the branching part 1400 and may pass between the first thermoelectric module 1200 and the first guide plate 1800-1 and between the second thermoelectric module 1300 and the second guide plate 1800-2.

Meanwhile, a width W1 between an outer side of a first heatsink 1220 of the first thermoelectric module 1200 and an outer side of a second heatsink 1320 of the second thermoelectric module 1300 may be greater than a width W2 of the branching part 1400. In this case, the outer side of the first heatsink 1220 and the outer side of the second heatsink 1320 may be sides opposite to sides facing the fluid flow part 1100. In this case, each of the first heatsink 1220 and the second heatsink 1320 may include a plurality of radiation fins, and the plurality of radiation fins may be formed in a direction in which a flow of gas is not hindered. For example, the plurality of radiation fins may have a plate shape extending in a second direction in which the gas flows. Alternatively, the plurality of radiation fins may also have a shape folded so that a flow path is formed in the second direction in which the gas flows. In this case, a maximum width W1 between the first heatsink 1220 of the first thermoelectric module 1200 and the second heatsink 1320 of the second thermoelectric module 1300 may be a distance from a farthest point of the first heatsink 1220 to a farthest point of the second heatsink 1320 from the fluid flow part 1100, and a maximum width W2 of the branching part 1400 may be a width of the branching part 1400 in a region closest to the third surface 1130 of the fluid flow part 1100. Accordingly, a flow of the second fluid may not be hindered by the branching part 1400 and may be directly transferred to the first heatsink 1220 and the second heatsink 1320. Accordingly, contact areas of the second fluid and the first and second heatsinks 1220 and 1320 increase, an amount of heat of the first heatsink 1220 and the second heatsink 1320 receiving from the second fluid increases, and thus a power generation efficiency can be improved.

Meanwhile, the first guide plate 1800-1 may be symmetrical to and spaced a predetermined distance from the first heatsink 1220 of the first thermoelectric module 1200, and the second guide plate 1800-2 may be symmetrical to and spaced a predetermined distance from the second heatsink 1320 of the second thermoelectric module 1300. In this case, distances between the guide plates 1800-1 and 1800-2 and the heatsinks of the thermoelectric modules may affect an amount of the second fluid in contact with the heatsinks of the thermoelectric modules and a pressure difference of the second fluid and thus affect the power generation performance.

According to the embodiment of the present invention, the power generation device, in which the thermoelectric modules are disposed on the surfaces of the fluid flow part, is for generating electricity using a difference in temperature between the first fluid passing through the inner portion of the fluid flow part and the second fluid passing the heatsinks of the thermoelectric module. In this case, a flow path of the first fluid passing through the inner portion of the fluid flow part needs to be formed in a region in which the thermoelectric legs of the thermoelectric module is disposed. Accordingly, a design of the flow path for obtaining a high cooling efficiency per an area is required.

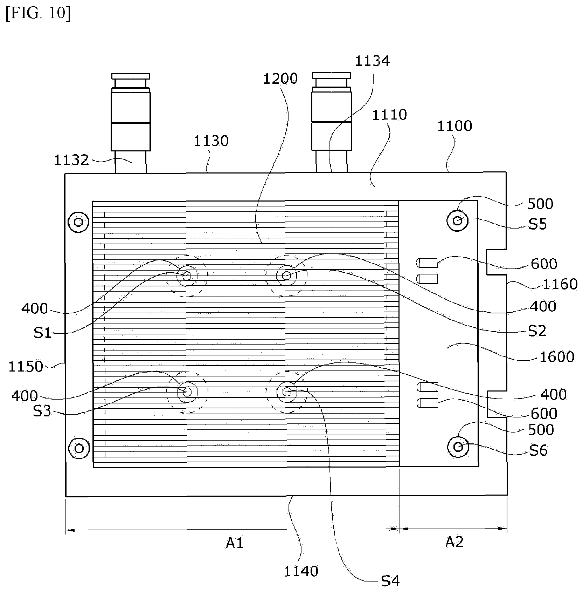

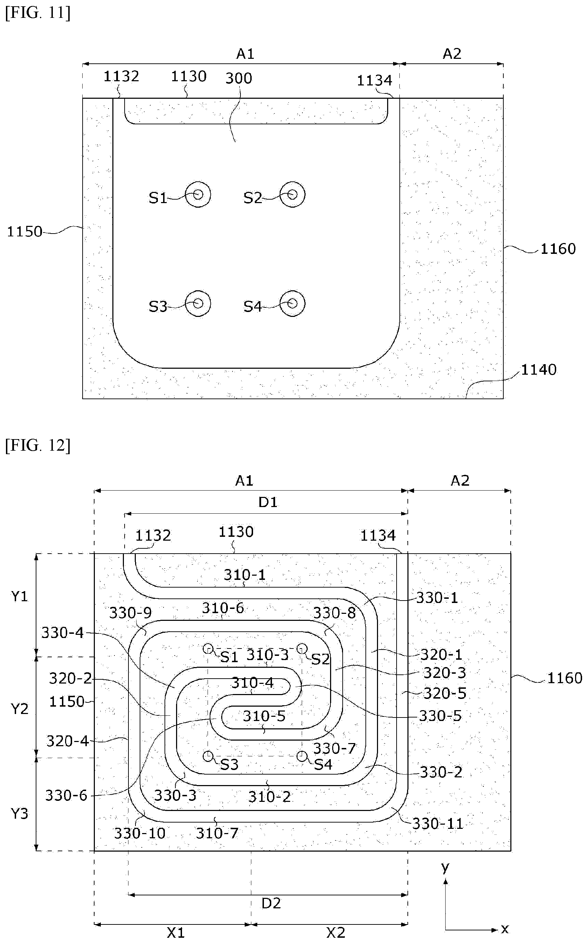

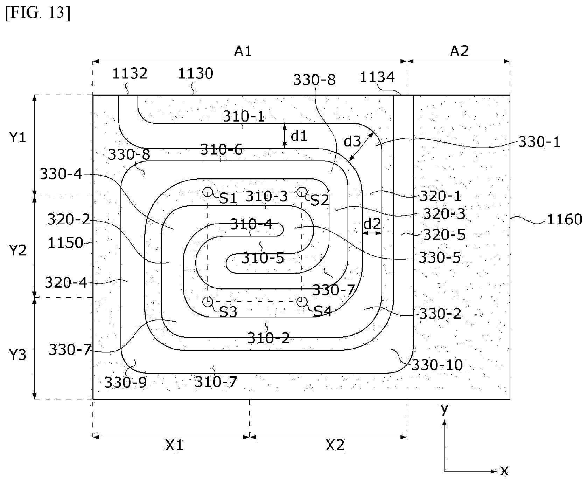

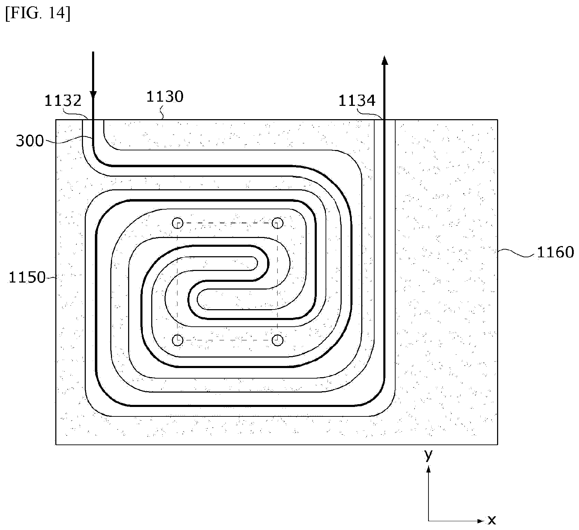

FIG. 10 is a top view illustrating a power generation module according to one embodiment of the present invention, and FIG. 11 is a cross-sectional view illustrating a fluid flow part according to one embodiment of the present invention. FIG. 12 is a cross-sectional view illustrating a fluid flow part according to another embodiment of the present invention, and FIG. 13 is a cross-sectional view illustrating a fluid flow part according to still another embodiment of the present invention. FIG. 14 is a view illustrating a fluid moving path of the fluid flow part of FIG. 13.

Referring to FIGS. 10 to 14, the power generation module according to one embodiment of the present invention includes a fluid flow part 1100 and a first thermoelectric module 1200 disposed on a first surface 1110 of the fluid flow part 1100. A second thermoelectric module 1300 may be further disposed on a second surface 1120 opposite to the first surface 1110 of the fluid flow part 1100.

A fluid inlet 1132 and a fluid outlet 1134 are disposed to be spaced apart from each other on another surface, that is, a third surface 1130 perpendicular to the first surface 1110 of the fluid flow part 1100, and a fluid accommodation part 300 is disposed in one region A1 of the fluid flow part 1100. In the present specification, since the first thermoelectric module 1200 and the second thermoelectric module 1300 are disposed on the first surface 1110 and the second surface 1120 of the fluid flow part 1100, the first surface 1110 and the second surface 1120 of the fluid flow part 1100 may be referred to as one surface and the other surface of the fluid flow part 1100. In addition, third to sixth surfaces 1130 to 1160 between the first surface 1110 and the second surface 1120 of the fluid flow part 1100 may be referred to as side surfaces or outer side surfaces of the fluid flow part 1100. The first fluid introduced through the fluid inlet 1132 may be discharged through the fluid outlet 1134 after passing through the fluid accommodation part 300. In this case, an arrangement order of the fluid inlet 1132 and the fluid outlet 1134 is not limited to an illustrated order, and positions of the fluid inlet 1132 and the fluid outlet 1134 may also be reversed therefrom. According to one embodiment of the present invention, the first thermoelectric module 1200 is disposed in the one region A1 of the fluid flow part 1100. Accordingly, an effective region, that is, thermoelectric legs, of the first thermoelectric module 1200 may be disposed in a region in which the fluid accommodation part 300 is disposed. A second fluid having a temperature greater than a temperature of the first fluid passing through the fluid flow part 1100 may pass heatsinks of the thermoelectric module 1200 in a direction from the fifth surface 1150 of the fluid flow part 1100 toward the sixth surface 1160 opposite to the fifth surface 1150.

Meanwhile, coupling members 400 may be used for coupling between the fluid flow part 1100 and the first thermoelectric module 1200. In order to symmetrically arrange the first thermoelectric module 1200 and the second thermoelectric module 1300 on two surfaces of the fluid flow part 1100, the coupling members 400 may be disposed to pass through the first thermoelectric module 1200, the fluid flow part 1100, and the second thermoelectric module 1300, and to this end, a plurality of through-holes S1 to S4, through which the coupling members 400 pass, may be formed in the fluid flow part 1100. The plurality of through-holes S1 to S4 may be disposed to pass through two surfaces of the fluid flow part 1100 on which the first thermoelectric module 1200 and the second thermoelectric module 1300 are disposed.

In this case, the plurality of through-holes S1 to S4 may be disposed to be spaced apart from the fluid accommodation part 300 in the one region A1 of the fluid flow part 1100 which is a region in which the fluid accommodation part 300 is disposed. That is, the plurality of through-holes S1 to S4 may be formed to be independent of the fluid accommodation part 300, and accordingly, a problem that the first fluid passing through the fluid accommodation part 300 is leaked to the outside through the plurality of through-holes S1 to S4 can be prevented.

Meanwhile, a wire part (not shown) connected to the first thermoelectric module 1200 and a shield member 1600 which covers the wire part may be further disposed in the first surface 1110 of the other region A2 of the fluid flow part 1100 disposed a side surface of the one region A1 of the fluid flow part 1100. Coupling members 500 may be used for coupling between the fluid flow part 1100 and the shield member1600, and a plurality of through-holes S5 and S6 through which the coupling members 500 for coupling between the fluid flow part 1100 and the shield member1600 pass may be formed in the other region A2 of the fluid flow part 1100. That is, the plurality of through-holes S5 and S6 may be formed not to overlap the fluid accommodation part 300 outside the one region A1 of the fluid flow part 1100 which is the region in which the fluid accommodation part 300 is disposed. In this case, the plurality of through-holes S5 and S6 may be disposed in consideration of a position of the wire part. That is, the wire part connected to the thermoelectric module may include a connection electrode (not shown) connected to a thermoelectric element of the thermoelectric module, connectors 600 disposed on the connection electrode, and a wire (not shown) connected to the connector 600. In this case, the plurality of through-holes S5 and S6 may be disposed to avoid positions of the connectors 600. Accordingly, the through-hole S5 may be disposed closer to the third surface 1130 than a plurality of through-holes S1 and S2, and the through-hole S6 may be disposed closer to the fourth surface 1140 than a plurality of through-holes S3 and S4.

In this case, positions and the number of a plurality of through-holes S1 to S6 are exemplary, and the embodiment of the present invention is not limited thereto. For the sake of convenience in the description, in FIGS. 11 to 14, the through-holes S5 to S of the region A2 are omitted but are not limited thereto.

Hereinafter, various embodiments of a shape of the fluid accommodation part 300 of the fluid flow part 1100 and a layout of the through-holes will be described with reference to FIGS. 11 to 14. Hereinafter, since the fluid accommodation part may form a flow path from the fluid inlet 1132 to the fluid outlet 1134, the fluid accommodation part may be referred to as a flow path and may also be referred to as a flow path pipe.

Referring to FIG. 11, a fluid accommodation part 300 in a fluid flow part 1100 may be disposed in a region A1 of the fluid flow part 1100 which is a region corresponding to a region in which thermoelectric modules 1200 and 1300 are disposed, and a first fluid introduced through a fluid inlet 1132 may be discharged from a fluid outlet 1134 after passing through the fluid accommodation part 300.

In this case, the fluid accommodation part 300 does not form a separate flow path pipe, and a plurality of through-holes S1 to S4 may be disposed to be spaced apart from the fluid accommodation part 300. Accordingly, since the region in which the fluid accommodation part 300 is disposed to correspond to the region in which the thermoelectric modules 1200 and 1300 are disposed, a lower-temperature part of a thermoelectric module may have a cooling ability. In addition, since the through-holes S1 to S4 are formed in the first region A1 of the fluid flow part 1100, the first thermoelectric module 1200 and the second thermoelectric module 1300 may be directly coupled to the fluid flow part 1100 by coupling members 400, and since the through-holes S1 to S4 are formed to be spaced apart from and independent of the fluid accommodation part 300, a problem that the first fluid in the fluid accommodation part 300 is leaked to the outside through the through-holes S1 to S4 can be prevented.

Alternatively, referring to FIGS. 12 to 14, a fluid accommodation part 300 may have a shape of a flow path pipe connecting a fluid inlet 1132 to a fluid outlet 1134, and a first fluid introduced through the fluid inlet 1132 may be discharged through the fluid outlet 1134 after flowing along the flow path pipe. As described above, when the fluid accommodation part 300 has the shape of the flow path pipe, according to the layout of the flow path pipe, the first fluid with a minimum amount may pass an entire region A1 in which a first thermoelectric module 1200 and a second thermoelectric module 1300 are disposed.

In this case, the flow path pipe may be disposed to be spaced apart from a plurality of through-holes S1 to S4. Accordingly, a problem that the first fluid in the fluid accommodation part 300 is leaked through the through-holes S1 to S4 can be prevented.

For example, the fluid accommodation part 300 may include a plurality of first flow path parts 310 disposed in a first direction X, a plurality of second flow path parts 320 disposed in a second direction Y perpendicular to the first direction X, and a plurality of bent parts 330 which are disposed between and connected to the plurality of first flow path parts 310 and the plurality of second flow path parts 320.

In this case, the first direction X may be a direction parallel to a direction in which a second fluid passes, and the second direction Y may be a direction parallel to a direction in which the first fluid is introduced and discharged. That is, the first direction X may be a direction from a fifth surface 1150 of a fluid flow part 1100 toward a sixth surface 1160 or vice versa, and the second direction Y may be a direction from a third surface 1130 of the fluid flow part 1100 toward a fourth surface 1140 or vice versa.

According to the embodiment of the present invention, from the third surface 1130 to the fourth surface 1140, a section Y1, a section Y2, and a section Y3 may be sequentially and arbitrarily set. In addition, the plurality of first flow path parts 310 may be disposed so that the first fluid sequentially passes through the section Y1, the section Y3, the section Y2, and the section Y1 and the section Y3. That is, the plurality of flow path parts 310 may be connected to the fluid inlet 1132 so that the first fluid sequentially passes through a first flow path part 310-1 passing through the section Y1, a first flow path part 310-2 passing through the section Y3, a plurality of first flow path parts 310-3, 310-4, and 310-5 passing through the section Y2, a first flow path part 310-6 that also passes through the section Y1, and a first flow path part 310-7 that also passes through the section Y3.

As described above, when the plurality of first flow path parts 310 are disposed so that the first fluid alternately passes through the section Y1 which is a section relatively close to the fluid inlet 1132 and the section Y3 which is a section relatively far from the fluid inlet 1132, since the entirety of the fluid flow part 1100 has a uniform temperature distribution, the uniform thermoelectric performance can be obtained in entire regions of the thermoelectric modules.

In this case, directions in which the first fluid passes through two first flow path parts 310-1 and 310-6 in the section Y1 may be opposite to each other, directions in which the first fluid passes through two first flow path parts 310-2 and 310-7 in the section Y3 may be opposite to each other, and a direction in which the first fluid passes through the first flow path part 310-1 disposed closer to the third surface 1130 between two first flow path parts 310-1 and 310-6 in the section Y1 and a direction in which the first fluid passes through the first flow path part 310-7 closer to the fourth surface 1140 between two first flow path parts 310-2 and 310-7 in the section Y3 may be directions the same as a direction in which the second fluid flows. Accordingly, among the plurality of first flow path parts, the directions in which the first fluid passes through the first flow path parts 310-1 and 310-7 disposed closest to the third surface 1130 and the fourth surface 1140 may be the same as a direction from the fluid inlet 1132 toward the fluid outlet 1134, and thus a temperature distribution may be uniform regardless of positions in the fluid accommodation part, and the uniform thermoelectric performance can be obtained in the entire regions of the thermoelectric modules.

Meanwhile, according to the embodiment of the present invention, three first flow path parts, that is, a plurality of first flow path parts 310-3, 310-4, and 310-5 may pass through the section Y2. In this case, the first fluid sequentially passing through the plurality of first flow path parts 310-3, 310-4, and 310-5 may flow to pass therethrough in the direction which is the same as the direction in which the second fluid flows, pass therethrough in the direction opposite to the direction in which the second fluid flows, and pass therethrough again in the direction which is the same as the direction in which the second fluid flows. In this case, the plurality of first flow path parts 310-3, 310-4, and 310-5 passing through the section Y2 may be disposed in a region defined by a virtual line connecting the plurality of through-holes S1 to S4. Accordingly, since the first fluid may be allowed to uniformly flow even in a central region of the fluid accommodation part 300, a temperature distribution can be uniformly maintained in the fluid accommodation part 300, generation of a dead zone can be prevented, and thus the uniform thermoelectric performance can be obtained in the entire regions of the thermoelectric modules.

Meanwhile, according to the embodiment of the present invention, from the fifth surface 1150 to the sixth surface 1160, a section X1 and a section X2 may be sequentially and arbitrarily set. In this case, the section X1 may be a section including the fluid inlet 1132, and the section X2 may be a section including the fluid outlet 1134. In addition, the plurality of second flow path parts 320 may be disposed so that the first fluid alternately passes through the section X1 and the section X2. That is, the plurality of second flow path parts 320 may be disposed so that the first fluid passes through the second flow path part 320-1 which is disposed between the first flow path part 310-1 of the section Y1 and the first flow path part 310-2 of the section Y3 and passes through the section X2, the second flow path part 320-2 which is disposed between the first flow path part 310-2 of the section Y3 and the first flow path part 310-3 of the section Y2 and passes through the section X1, the second flow path part 320-3 which is disposed between the first flow path part 310-5 of the section Y2 and the first flow path part 310-6 of the section Y1 and passes through the section X2, the second flow path part 320-4 which is disposed between the first flow path part 310-6 of the section Y1 and the first flow path part 310-7 of the section Y3 and passes through the section X1, and the second flow path part 320-5 which is disposed between the first flow path part 310-7 of the section Y3 and the fluid outlet 1134 and passes through the section X2.

As described above, when the plurality of second flow path parts 320 are disposed so that the first fluid alternately passes through the section X1 which is a section relatively close to the fluid inlet 1132 and the section X2 which is a section relatively close to the fluid outlet 1134, the entirety of the fluid accommodation part 300 can have a uniform temperature distribution, and thus the uniform thermoelectric performance can be obtained in the entire region of the thermoelectric module.

In this case, the plurality of second flow path parts 320 may be disposed outside the region defined by the virtual line connecting the plurality of through-holes S1 to S4. Accordingly, the first fluid can uniformly flow even in an edge region of the fluid accommodation part 300, generation of a dead zone can be prevented, and thus the uniform thermoelectric performance can be obtained in the entire regions of the thermoelectric modules.

Meanwhile, according to the embodiment of the present invention, a distance D1 between the fluid inlet 1132 and the fluid outlet 1134 may be greater than a distance D2 between the second flow path part 320-4 closest to the fifth surface 1150 among the plurality of second flow path parts 320 and the second flow path part 320-5 closest to the sixth surface 1160 among the plurality of second flow path parts 320. Accordingly, a bent region on a path of a fluid pipe can be minimized to minimize congestion of the first fluid, and a shortest length of the path of the fluid pipe can be implemented.

Meanwhile, according to the embodiment of the present invention, the fluid pipe includes the plurality of bent parts 330. Some bent parts 330-1, 330-2, 330-3, 330-4, 330-7, 330-8, 330-9, 330-10, and 330-11 of the plurality of bent parts 330 may connect one of the plurality of first flow path parts 310 and one of the plurality of second flow path parts 320, and some other bent parts 330-5 and 330-6 of the plurality of bent parts 330 may connect two of the plurality of first flow path parts 310. In this case, some other bent parts 330-5, 330-6 of the plurality of bent parts 330 may be disposed in the region defined by the virtual line connecting the plurality of through-holes S1 to S4. As described above, when the plurality of first flow path parts 310 and the plurality of second flow path parts 320 are connected by the plurality of bent parts 330, since a flow of the first fluid is guided by a wall surface of the bent part 330, a flow congestion section can be minimized.

In this case, as illustrated in FIGS. 13 and 14, a diameter d3 of at least one of the plurality of bent parts 330 may be greater than each of a diameter d1 of at least one of the plurality of first flow path parts 310 and a diameter d2 of at least one of the plurality of second flow path parts 320. In this case, the diameters d1, d2, and d3 of the first flow path part 310, the second flow path part 320, and the bent part 330 may be distances between inner wall surfaces in the flow path along which the first fluid flows. Accordingly, a movement resistance of the first fluid in the bent part 330 can be minimized, and thus, the entirety of the fluid accommodation part 300 can have a uniform flow rate.

In this case, each of the diameters d1 and d2 of the first flow path part 310 and the second flow path part 320 may 5 mm or more, preferably 7 mm or more, and more preferably 9 mm or more, and the diameter d3 of the bent part 330 may be 1.1 times or higher, preferably 1.2 times or higher, and more preferably 1.3 times or higher each of the diameters d1 and d2 of the first flow path part 310 and the second flow path part 320. Accordingly, a high cooling efficiency can be obtained in comparison to an area occupied by the fluid accommodation part 300 and a flow rate.

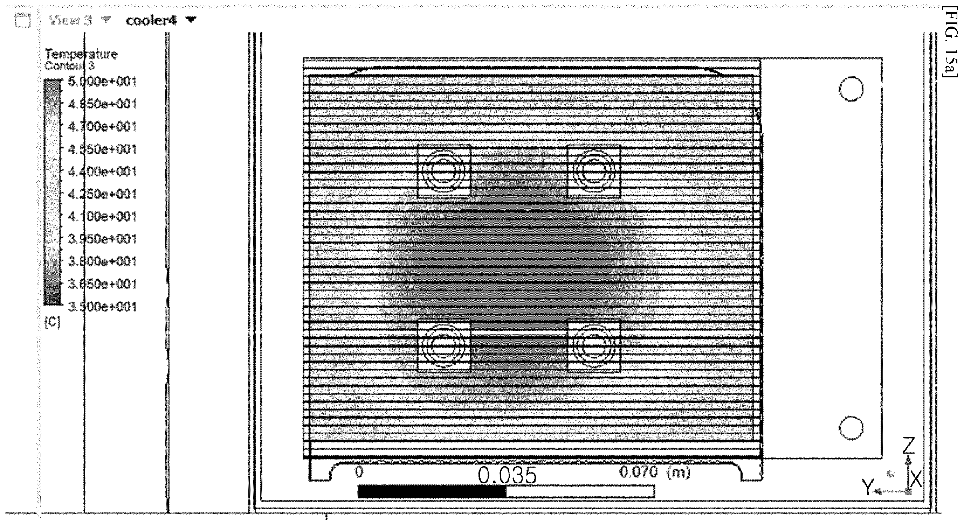

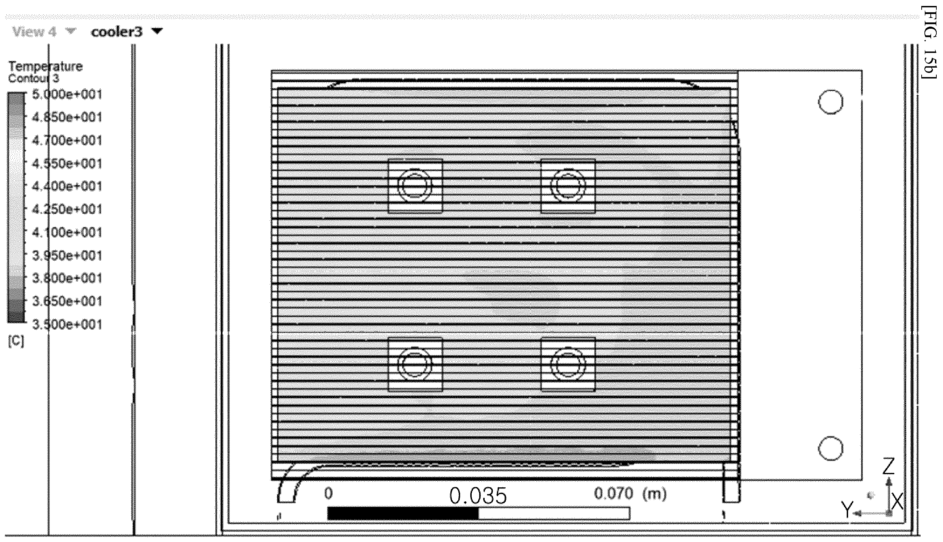

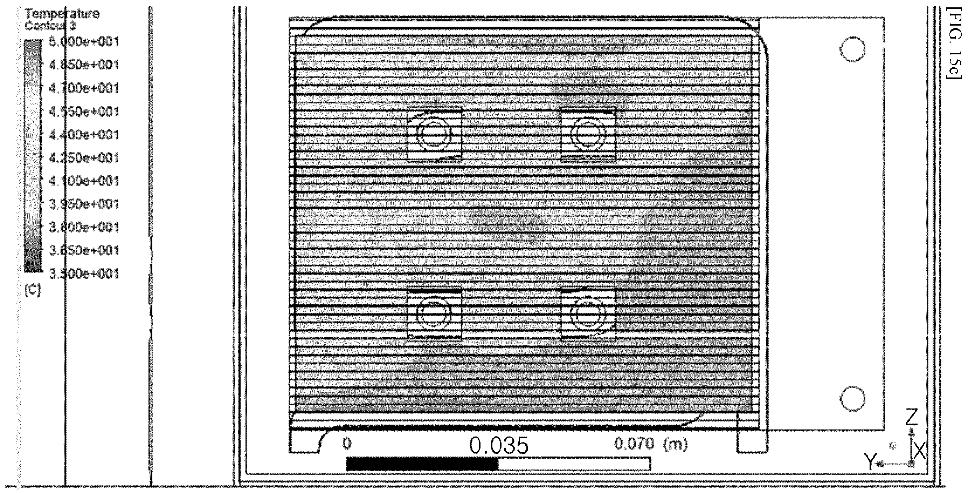

Table 1 shows a simulation result of a difference in temperature of a thermoelectric module when a flow path has a shape illustrated in FIGS. 11 to 13. FIG. 15A is a view showing a simulation result of a heat distribution in a flow path shape of FIG. 11, FIG. 15B is a view showing a simulation result of a heat distribution in a flow path shape of FIG. 12, and FIG. 15C is a view showing a simulation result of a heat distribution in a flow path shape of FIG. 13.

[Table 1]

| SHAPE OF FLOW PATH | AREA OF FLOW PATH (mm²) | LENGTH OF FLOW PATH (mm) | WIDTH OF FLOW path(mm) | TEMPERATURE OF HIGH-TEMPERATURE PART (K) | TEMPERATURE OF LOW-TEMPERATURE PART (K) | DIFFERENCE IN TEMPERATURE(K) | IMPROVEMENT RATE(%) |
|---|---|---|---|---|---|---|---|
| FIG. 11 | 9279 | - | - | 400 | 318.3 | 81.7 | 0 |
| FIG. 12 | 3054 | 763.5 | 5 | 397.1 | 312.1 | 85.1 | 3.9 |
| FIG. 14 | 6864.3 | 763.5 | 9 | 396.9 | 309.8 | 87.1 | 6.2 |

Referring to Table 1, although the areas of flow paths in the flow path shapes illustrated in FIGS. 12 and 12 are decreased compared to the area of the flow path shape illustrated in FIG. 11, it can be seen that a difference in temperature in the thermoelectric module is significantly improved. Particularly, as illustrated in FIG. 13, when a width of the flow path is increased compared to the width of the flow path shape of FIG. 12, since heat exchange area may be increased even when a length is the same as a length of the flow path of FIG. 12, it can be seen that a difference in temperature in the thermoelectric module is further improved.

In addition, referring to FIGS. 15A to 15C, it can be seen that the flow path shapes of the FIGS. 12 and 13 have uniform temperature distributions compared to the flow path shape of FIG. 11, and thus the high cooling performance can be expected.

As described above, according to the embodiment of the present invention, it can be seen that, since the length of the flow path is minimized to reduce heat loss of the fluid, and the width of the flow path is increased to increase the heat exchange area, a difference in temperature between a high-temperature part and a lower-temperature part can be improved.

Meanwhile, for the sake of convenience in the description, although the present invention has been described above based on one power generation device but is not limited thereto. A plurality of power generation devices may also be disposed in one fluid passing part 2200.

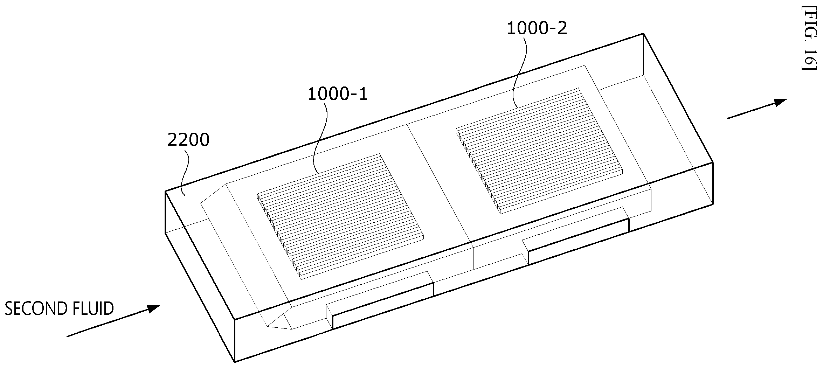

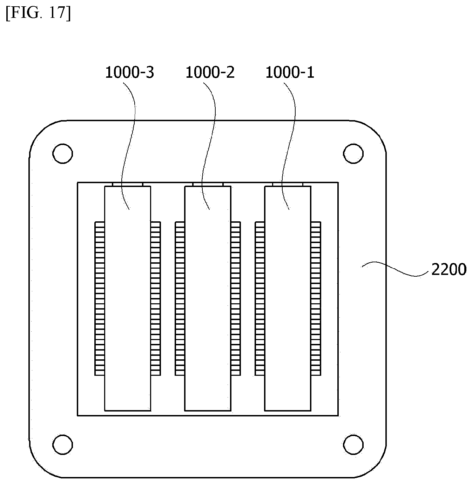

FIG. 16 is a view illustrating a power generation system according to another embodiment of the present invention, and FIG. 17 is a view illustrating a power generation system according to still another embodiment of the present invention.

Referring to FIGS. 16 and 17, the power generation system may include a plurality of power generation devices, and each of the power generation devices may be the same as the power generation device described with reference to FIGS. 1 to 14.

Referring to FIG. 16, a plurality of power generation devices 1000-1 and 1000-2 may be disposed in a direction in which a second fluid flows in a fluid passing part 2200.

Alternatively, referring to FIG. 17, a plurality of power generation devices 1000-1, 1000-2, and 1000-3 may also be disposed in parallel to be spaced apart from each other in a fluid passing part 2200.

A layout and the number of the plurality of power generation devices may be changed according to power generation amount and the like.

The power generation system can generate power using heat generated by a vessel, a vehicle, a power plant, or the ground, and a plurality of power generation devices can be arranged in order to effectively collect the heat. In this case, in each of the power generation devices, a flow path in a cooling part can be improved to improve the cooling performance of a lower-temperature part of a thermoelectric element, accordingly, an efficiency and reliability of the power generation device can be improved, and thus a fuel efficiency of a transportation apparatus such as a vessel or a vehicle can be improved. Accordingly, in the transportation industry, transportation costs can be reduced, an eco-friendly industrial environment can be created, and when the power generation device is applied to a manufacturing industry such as a steel mill, material costs and the like can be reduced.

While the present invention has been described with reference to exemplary embodiments thereof, it will be understood by those skilled in the art that the present invention may be variously changed and modified without departing from the scope of the present invention defined by the appended claims below.

**Claims**

1.   A power generation device comprising:

a fluid flow part (1100) in which a flow path pipe is formed and which includes a first surface (1110), a second surface (1120) opposite to the first surface (1110), a third surface (1130) between the first surface (1110) and the second surface (1120), a fourth surface (1140) opposite to the third surface (1130), a fifth surface (1150) between the first surface (1110), the second surface (1120), the third surface (1130), and the fourth surface (1140), and a sixth surface (1160) opposite to the fifth surface (1150); and
a first thermoelectric module (1200) disposed on the first surface (1110),
wherein a fluid inlet (1132) and a fluid outlet (1134) are disposed in the third surface (1130),
the flow path pipe is formed to connect from the fluid inlet (1132) to the fluid outlet (1134),
the flow path pipe includes a plurality of first flow path parts (310) disposed in a first direction, a plurality of second flow path parts (320) disposed in a second direction perpendicular to the first direction, and a plurality of bent parts (330) disposed between and connected to the plurality of first flow path parts (310) and the plurality of second flow path parts (320),
a first section (Y1), a second section (Y2), and a third section (Y3) of the fluid flow part (1100) are sequentially disposed from the third surface (1130) to the fourth surface (1140),
a plurality of through-holes (S1~S4) passing through the first surface (1110) are formed in the fluid flow part (1100), **characterized in that**:

the plurality of first flow path parts (310-3, 310-4, 310-5) disposed in the second section (Y2) and the bent parts (330-5, 330-6) connecting the plurality of first flow path parts (310-3, 310-4, 310-5) disposed in the second section (Y2) are disposed in a region defined by a virtual line connecting the plurality of through-holes (S1~S4),
the fluid inlet (1132) and the fluid outlet (1134) are disposed spaced apart from each other in the first direction, and
a distance (D1) between the fluid inlet (1132) and the fluid outlet (1134) is greater than or equal to a distance (D2) between the second flow path part (320-4) closest to the fifth surface (1150) among the plurality of second flow path parts (320) and the second flow path part (320-5) closest to the sixth surface (1160) among the plurality of second flow path parts (320).

2. The power generation device of claim 1, wherein:

the first thermoelectric module (1200) includes a first thermoelectric element (1210) disposed on the first surface (1110) and a first heatsink (1220) disposed on the first thermoelectric element (1220);
the fluid configured to pass through the fluid flow part is a first fluid;
a second fluid of which a temperature is different from a temperature of the first fluid is configured to pass the first heatsink (1220) in a direction from the fifth surface (1150) toward the sixth surface (1160); and
the first direction is parallel to a direction in which the second fluid passes.

3. The power generation device of claim 2, comprising a fourth section (X1) and a fifth section (X2) from the fifth surface (1150) to the sixth surface (1160).

4. The power generation device of claim 3, wherein, in the flow path pipe, the first flow path part (310-1) connected to the fluid inlet(1132) and passing through the first section (Y1), the second flow path part (320-1) passing through the fifth section (X2), the first flow path part (310-2) passing through the third section (Y3), the second flow path part (320-2) passing through the fourth section (X1), the plurality of first flow path parts (310-3, 310-4, 310-5) passing through the second section (Y2), the second flow path part (320-3) passing through the fifth section (X2), the first flow path part (310-6) passing through the first section (Y1), the second flow path part (320-4) passing through the fourth section (X1), the first flow path part (310-7) passing through the third section (Y3), and the second flow path part (320-5) passing through the fifth section (X2) and connected to the fluid outlet (1134) are sequentially connected.

5. The power generation device of claim 4, wherein:

directions in which the first fluid is configured to pass through two first flow path parts (310-1, 310-6) passing through the first section (Y1) are opposite to each other, and
directions in which the first fluid is configured to pass through two first flow path parts (310-2, 310-7) passing through the third section (Y3) are opposite to each other.

6. The power generation device of claim 5, wherein a direction in which the first fluid is configured to pass through the first flow path part (310-1) disposed closer to the third surface (1130) among the two first flow path parts (310-1, 310-6) passing through the first section (Y1) and a direction in which the first fluid is configured to pass through the first flow path part (310-7) disposed closer to the fourth surface (1140) among the two first flow path parts (310-2, 310-7) passing through the third section (Y3) are the same as the direction in which the second fluid is configured to flow.

7. The power generation device of claim 6, wherein:
the first fluid in the plurality of first flow path parts (310-3, 310-4, 310-5) passing through the second section (Y2) is configured to pass in a direction which is the same as the direction in which the second fluid is configured to flow, to pass in a direction which is opposite to the direction in which the second fluid is configured to flow, and then to pass again in the direction which is the same as the direction in which the second fluid is configured to flow.

8. The power generation device of claim 1, wherein:
the fluid flow part (1100) and the first thermoelectric module (1200) are coupled by a plurality of coupling members disposed in the plurality of through-holes (S1~S4).

9. The power generation device of claim 1,
wherein the plurality of second flow path parts(320) are disposed outside the region defined by the virtual line connecting the plurality of through-holes (S1~S4).

10. The power generation device of claim 1, wherein a diameter of at least one of the plurality of bent parts (330) is greater than each of a diameter of at least one of the plurality of first flow path parts (310) and a diameter of at least one of the plurality of second flow path parts (320).

11. The power generation device of claim 10, wherein a diameter of at least one of the plurality of bent parts (330) is 1.1 times or more of each of a diameter of at least one of the plurality of first flow path parts (310) and a diameter of at least one of the plurality of second flow path parts (320).

12. The power generation device of claim 2, further comprising a second thermoelectric module (1300) including a second thermoelectric element (1310) disposed on the second surface (1120) and a second heatsink (1320) disposed on the second thermoelectric element (1310),
wherein the second fluid is configured to pass the second heatsink (1320) in a direction from the fifth surface (1150) toward the sixth surface (1160).

**Patentansprüche**

1. Energieerzeugungsvorrichtung umfassend:

ein Fluidströmungsteil (1100), in dem ein Strömungspfadrohr gebildet ist und das eine erste Oberfläche (1110), eine zweite Oberfläche (1120) gegenüber der ersten Oberfläche (1110), eine dritte Oberfläche (1130) zwischen der ersten Oberfläche (1110) und der zweiten Oberfläche (1120), eine vierte Oberfläche (1140) gegenüber der dritten Oberfläche (1130), eine fünfte Oberfläche (1150) zwischen der ersten Oberfläche (1110), der zweiten Oberfläche (1120), der dritten Oberfläche (1130) und der vierten Oberfläche (1140), und eine sechste Oberfläche (1160) gegenüber der fünften Oberfläche (1150) umfasst; und
ein erstes thermoelektrisches Modul (1200), das auf der ersten Oberfläche (1110) angeordnet ist,
wobei ein Fluideinlass (1132) und ein Fluidauslass (1134) in der dritten Oberfläche (1130) angeordnet sind,
das Strömungspfadrohr gebildet ist, um von dem Fluideinlass (1132) zu dem Fluidauslass (1134) zu verbinden,
das Strömungspfadrohr eine Vielzahl von ersten Strömungspfadteilen (310), die in einer ersten Richtung angeordnet sind, eine Vielzahl von zweiten Strömungspfadteilen (320), die in einer zu der ersten Richtung senkrechten zweiten Richtung angeordnet sind, und eine Vielzahl von gebogenen Teilen (330) umfasst, die zwischen der Vielzahl von ersten Strömungspfadteilen (310) und der Vielzahl von zweiten Strömungspfadteilen (320) angeordnet und mit diesen verbunden sind,
eine erste Sektion (Y1), eine zweite Sektion (Y2) und eine dritte Sektion (Y3) des Fluidströmungsteils (1100) von der dritten Oberfläche (1130) zu der vierten Oberfläche (1140) nacheinander angeordnet sind,
eine Vielzahl von Durchgangslöchern (S1~S4), die durch die erste Oberfläche (1110) hindurchgehen, in dem Fluidströmungsteil (1100) gebildet sind,
**dadurch gekennzeichnet, dass**:

die Vielzahl von ersten Strömungspfadteilen (310-3, 310-4, 310-5), die in der zweiten Sektion (Y2) angeordnet sind, und die gebogenen Teile (330-5, 330-6), welche die Vielzahl von ersten Strömungspfadteilen (310-3, 310-4, 310-5) verbinden, die in der zweiten Sektion (Y2) angeordnet sind, in einem Bereich angeordnet sind, der durch eine virtuelle Linie definiert ist, welche die Vielzahl von Durchgangslöchern (S1~S4) verbindet,
der Fluideinlass (1132) und der Fluidauslass (1134) in der ersten Richtung voneinander beabstandet angeordnet sind, und
ein Abstand (D1) zwischen dem Fluideinlass (1132) und dem Fluidauslass (1134) größer als ein oder gleich einem Abstand (D2) zwischen dem zweiten Strömungspfadteil (320-4), das unter der Vielzahl von zweiten Strömungspfadteilen (320) am nächsten bei der fünften Oberfläche (1150) ist, und dem zweiten Strömungspfadteil (320-5) ist, das unter der Vielzahl von zweiten Strömungspfadteilen (320) am nächsten zu der sechsten Oberfläche (1160) ist.

2. Energieerzeugungsvorrichtung nach Anspruch 1, wobei:

das erste thermoelektrische Modul (1200) ein erstes thermoelektrisches Element (1210), das auf der ersten Oberfläche (1110) angeordnet ist, und eine erste Wärmesenke (1220) umfasst, die auf dem ersten thermoelektrischen Element (1220) angeordnet ist;

das Fluid, das dazu konfiguriert ist, durch das Fluidströmungsteil hindurchzugehen, ein erstes Fluid ist;

ein zweites Fluid, dessen Temperatur unterschiedlich von einer Temperatur des ersten Fluids ist, dazu konfiguriert ist, durch die erste Wärmesenke (1220) in einer Richtung von der fünften Oberfläche (1150) zu der sechsten Oberfläche (1160) hindurchzugehen; und

die erste Richtung parallel zu einer Richtung ist, in der das zweite Fluid hindurchgeht.

3. Energieerzeugungsvorrichtung nach Anspruch 2, umfassend eine vierte Sektion (X1) und eine fünfte Sektion (X2) von der fünften Oberfläche (1150) zu der sechsten Oberfläche (1160).

4. Energieerzeugungsvorrichtung nach Anspruch 3, wobei, in dem Strömungspfadrohr, das erste Strömungspfadteil (310-1), das mit dem Fluideinlass (1132) verbunden ist und durch die erste Sektion (Y1) hindurchgeht, das zweite Strömungspfadteil (320-1), das durch die fünfte Sektion (X2) hindurchgeht, das erste Strömungspfadteil (310-2), das durch die dritte Sektion (Y3) hindurchgeht, das zweite Strömungspfadteil (320-2), das durch die vierte Sektion (X1) hindurchgeht, die Vielzahl von ersten Strömungspfadteilen (310-3, 310-4, 310-5), die durch die zweite Sektion (Y2) hindurchgehen, das zweite Strömungspfadteil (320-3), das durch die fünfte Sektion (X2) hindurchgeht, das erste Strömungspfadteil (310-6), das durch die erste Sektion (Y1) hindurchgeht, das zweite Strömungspfadteil (320-4), das durch die vierte Sektion (X1) hindurchgeht, das erste Strömungspfadteil (310-7), das durch die dritte Sektion (Y3) hindurchgeht, und das zweite Strömungspfadteil (320-5), das durch die fünfte Sektion (X2) hindurchgeht und mit dem Fluidauslass (1134) verbunden ist, nacheinander verbunden sind.

5. Energieerzeugungsvorrichtung nach Anspruch 4, wobei

Richtungen, in denen das erste Fluid konfiguriert ist, durch zwei erste Strömungspfadteile (310-1, 310-6) hindurchzugehen, die durch die erste Sektion (Y1) hindurchgehen, zueinander entgegengesetzt sind, und

Richtungen, in denen das erste Fluid konfiguiert ist, durch zwei erste Strömungspfadteile (310-2, 310-7) hindurchzugehen, die durch die dritte Sektion (Y3) hindurchgehen, zueinander entgegengesetzt sind.

6. Energieerzeugungsvorrichtung nach Anspruch 5, wobei eine Richtung, in der das erste Fluid konfiguriert ist, durch das erste Strömungspfadteil (310-1) hindurchzugehen, das unter den zwei ersten Strömungspfadteilen (310-1, 310-6), die durch die erste Sektion (Y1) hindurchgehen, näher an der dritten Oberfläche (1130) angeordnet ist, und eine Richtung, in der das erste Fluid konfiguriert ist, durch das erste Strömungspfadteil (310-7) hindurchzugehen, das unter den zwei ersten Strömungspfadteilen (310-2, 310-7), die durch die dritte Sektion (Y3) hindurchgehen, näher an der vierten Oberfläche (1140) angeordnet ist, dieselben sind wie die Richtung, in der das zweite Fluid konfiguriert ist, zu strömen.

7. Energieerzeugungsvorrichtung nach Anspruch 6, wobei:
das erste Fluid in der Vielzahl von ersten Strömungspfadteilen (310-3, 310-4, 310-5), die durch die zweite Sektion (Y2) hindurchgehen, dazu konfiguriert ist, in einer Richtung hindurchzugehen, welche dieselbe wie die Richtung ist, in der das zweite Fluid konfiguriert ist, zu strömen, in einer Richtung hindurchzugehen, die entgegengesetzt zu der Richtung ist, in der das zweite Fluid konfiguriert ist, zu strömen, und dann wieder in der Richtung hindurchzugehen, welche dieselbe ist wie die Richtung, in der das zweite Fluid konfiguriert ist, zu strömen.

8. Energieerzeugungsvorrichtung nach Anspruch 1, wobei:
das Fluidströmungsteil (1100) und das erste thermoelektrische Modul (1200) durch eine Vielzahl von Kopplungselementen gekoppelt sind, die in der Vielzahl von Durchgangslöchern (S1~S4) angeordnet sind.

9. Energieerzeugungsvorrichtung nach Anspruch 1,
wobei die Vielzahl von zweiten Strömungspfadteilen (320) außerhalb des Bereichs angeordnet sind, der durch die virtuelle Linie definiert ist, welche die Vielzahl von Durchgangslöchern (S1~S4) verbindet.

10. Energieerzeugungsvorrichtung nach Anspruch 1, wobei ein Durchmesser von wenigstens einem der Vielzahl von gebogenen Teilen (330) größer als jeder eines Durchmessers von wenigstens einem der Vielzahl von ersten Strömungspfadteilen (310) und eines Durchmessers von wenigstens einem der Vielzahl von zweiten Strömungspfadteilen (320) ist.

**11.** Energieerzeugungsvorrichtung nach Anspruch 10, wobei ein Durchmesser von wenigstens einem der Vielzahl von gebogenen Teilen (330) das 1,1-Fache oder mehr von jedem eines Durchmessers von wenigstens einem der Vielzahl von ersten Strömungspfadteilen (310) und eines Durchmessers von wenigstens einem der Vielzahl von zweiten Strömungspfadteilen (320) ist.

**12.** Energieerzeugungsvorrichtung nach Anspruch 2, ferner umfassend ein zweites thermoelektrisches Modul (1300), das ein zweites thermoelektrisches Element (1310), das auf der zweiten Oberfläche (1120) angeordnet ist, und eine zweite Wärmesenke (1320) umfasst, die auf dem zweiten thermoelektrischen Element (1310) angeordnet ist, wobei das zweite Fluid dazu konfiguriert ist, durch die zweite Wärmesenke (1320) in einer Richtung von der fünften Oberfläche (1150) zu der sechsten Oberfläche (1160) hindurchzugehen.

**Revendications**

**1.** Dispositif de production d'énergie comprenant :

une partie d'écoulement de fluide (1100) dans laquelle est formé un conduit d'écoulement et qui comprend une première surface (1110), une deuxième surface (1120) opposée à la première surface (1110), une troisième surface (1130) située entre la première surface (1110) et la deuxième surface (1120), une quatrième surface (1140) opposée à la troisième surface (1130), une cinquième surface (1150) située entre la première surface (1110), la deuxième surface (1120), la troisième surface (1130) et la quatrième surface (1140), et une sixième surface (1160) opposée à la cinquième surface (1150) ; et
un premier module thermoélectrique (1200) disposé sur la première surface (1110), dans lequel une entrée de fluide (1132) et une sortie de fluide (1134) sont disposées dans la troisième surface (1130),
le conduit de circulation est formé de manière à relier l'entrée de fluide (1132) à la sortie de fluide (1134),
le conduit d'écoulement est formé de manière à relier l'entrée de fluide (1132) à la sortie de fluide (1134),

le conduit d'écoulement comprend une pluralité de premières portions de conduit (310) disposées selon une première direction, une pluralité de secondes portions de conduit (320) disposées selon une deuxième direction perpendiculaire à la première direction, et une pluralité de portions coudées (330) disposées entre et reliant lesdites premières portions de conduit (310) et lesdites secondes portions de conduit (320),
une première section (Y1), une deuxième section (Y2) et une troisième section (Y3) de la partie d'écoulement de fluide (1100) sont disposées successivement de la troisième surface (1130) vers la quatrième surface (1140),
une pluralité de trous traversants (S1 à S4) traversant la première surface (1110) sont formés dans la partie d'écoulement de fluide (1100),
**caractérisé en ce que** :

la pluralité de premières portions de conduit (310-3, 310-4, 310-5) disposées dans la deuxième section (Y2) et les portions coudées (330-5, 330-6) reliant ces premières portions de conduit (310-3, 310-4, 310-5) sont disposées dans une région définie par une ligne virtuelle reliant les trous traversants (S1 à S4),
l'entrée de fluide (1132) et la sortie de fluide (1134) sont espacées l'une de l'autre selon la première direction,
et une distance (D1) entre l'entrée de fluide (1132) et la sortie de fluide (1134) est supérieure ou égale à une distance (D2) entre la portion de conduit de second type (320-4) la plus proche de la cinquième surface (1150) parmi les secondes portions de conduit (320) et la portion de conduit de second type (320-5) la plus proche de la sixième surface (1160) parmi les secondes portions de conduit (320).

**2.** Dispositif de production d'énergie selon la revendication 1, dans lequel :

le premier module thermoélectrique (1200) comprend un premier élément thermoélectrique (1210) disposé sur la première surface (1110) et un premier dissipateur thermique (1220) disposé sur ledit élément thermoélectrique ;
le fluide configuré pour traverser la partie d'écoulement de fluide est un premier fluide ;
un second fluide dont la température est différente de celle du premier fluide est configuré pour traverser le dissipateur thermique (1220) dans une direction allant de la cinquième surface (1150) vers la sixième surface (1160) ;
et la première direction est parallèle à la direction d'écoulement du second fluide.

**3.** Dispositif de production d'énergie selon la revendication 2, comprenant une quatrième section (X1) et une cinquième section (X2) entre la cinquième surface (1150) et la sixième surface (1160).

**4.** Dispositif de production d'énergie selon la revendication 3, dans lequel, dans le conduit d'écoulement, la première portion de conduit (310-1) reliée à l'entrée de fluide (1132) et traversant la première section (Y1), la deuxième portion de conduit (320-1) traversant la cinquième section (X2), la première portion de conduit (310-2) traversant la troisième section (Y3), la deuxième portion de conduit (320-2) traversant la quatrième section (X1), les premières portions de conduit (310-3, 310-4, 310-5) traversant la deuxième section (Y2), la deuxième portion de conduit (320-3) traversant la cinquième section (X2),la première portion de conduit (310-6) traversant la première section (Y1), la deuxième portion de conduit (320-4) traversant la quatrième section (X1), la première portion de conduit (310-7) traversant la troisième section (Y3), et la deuxième portion de conduit (320-5) traversant la cinquième section (X2) et reliée à la sortie de fluide (1134) sont reliées en série.

**5.** Dispositif de production d'énergie selon la revendication 4, dans lequel :
les directions d'écoulement du premier fluide dans deux premières portions de conduit (310-1, 310-6) traversant la première section (Y1) sont opposées ; et
les directions d'écoulement du premier fluide dans deux premières portions de conduit (310-2, 310-7) traversant la troisième section (Y3) sont opposées.

**6.** Dispositif de production d'énergie selon la revendication 5, dans lequel la direction d'écoulement du premier fluide dans la première portion de conduit (310-1) située plus près de la troisième surface (1130) parmi les deux premières portions de conduit (310-1, 310-6) traversant la première section (Y1), et la direction d'écoulement du premier fluide dans la première portion de conduit (310-7) située plus près de la quatrième surface (1140) parmi les deux premières portions de conduit (310-2, 310-7) traversant la troisième section (Y3), sont identiques à la direction d'écoulement du second fluide.

**7.** Dispositif de production d'énergie selon la revendication 6, dans lequel :
le premier fluide dans les premières portions de conduit (310-3, 310-4, 310-5) traversant la deuxième section (Y2) est configuré pour s'écouler successivement dans une direction identique à celle du second fluide, puis dans une direction opposée, puis à nouveau dans une direction identique à celle du second fluide.

**8.** Dispositif de production d'énergie selon la revendication 1, dans lequel :
la partie d'écoulement de fluide (1100) et le premier module thermoélectrique (1200) sont assemblés par une pluralité d'éléments de fixation disposés dans les trous traversants (S1 à S4).

**9.** Dispositif de production d'énergie selon la revendication 1, dans lequel les secondes portions de conduit (320) sont disposées à l'extérieur de la région définie par la ligne virtuelle reliant les trous traversants (S1 à S4).

**10.** Dispositif de production d'énergie selon la revendication 1, le diamètre d'au moins une des portions coudées (330) est supérieur au diamètre d'au moins une des premières portions de conduit (310) et au diamètre d'au moins une des secondes portions de conduit (320).

**11.** Dispositif de production d'énergie selon la revendication 10, dans lequel le diamètre d'au moins une des portions coudées (330) est supérieur ou égal à 1,1 fois le diamètre d'au moins une des premières portions de conduit (310) et le diamètre d'au moins une des secondes portions de conduit (320).

**12.** Dispositif de production d'énergie selon la revendication 2, comprenant en outre un second module thermoélectrique (1300) comprenant un second élément thermoélectrique (1310) disposé sur la deuxième surface (1120) et un second dissipateur thermique (1320) disposé sur le second élément thermoélectrique (1310),
dans lequel le second fluide est configuré pour traverser le second dissipateur thermique (1320) dans une direction allant de la cinquième surface (1150) vers la sixième surface (1160).

[FIG. 1]

2000: 2100, 2200, 2300, 2400, 2500

[FIG. 2]

2000: 2100, 2200, 2300, 2400, 2500

[FIG. 3]

1900: 1900-1, 1900-2
1800: 1800-1, 1810-1, 1820-1, 1800-2, 1810-2, 1820-2

[FIG. 4]

1900: 1900-1, 1900-2

[FIG. 5]

[FIG. 6]

1100: 1110, 1120, 1130, 1140, 1150, 1160
1200: 1210, 1220
1300: 1310, 1320

[FIG. 7a]

[FIG. 7b]

1220, 1320

1230, 1330

1240, 1340

1220, 1320

S

1210, 1310

1210, 1310

1230, 1330    1240, 1340

[FIG. 8]

100

160

170

150

130

140

170

120

110

[FIG. 9]

[FIG. 10]

[FIG. 11]

[FIG. 12]

[FIG. 13]

[FIG. 14]

[FIG. 15a]

[FIG. 15b]

[FIG. 15c]

[FIG. 16]

[FIG. 17]

**EP 4 170 737 B1**

**Patent documents cited in the description**

- WO 2019194595 A1